# EUROPEAN PATENT APPLICATION

(11) **EP 4 648 000 A1**
(43) Date of publication of application: **12.11.2025**
(21) Application number: 23921351.5
(22) Date of filing: 14.12.2023
(51) Int. Cl.: G06Q 50/04, G06Q 30/06

(54) **PURCHASE ASSISTANCE DEVICE, PURCHASE ASSISTANCE METHOD, AND PURCHASE ASSISTANCE PROGRAM**

(30) Priority: 10.02.2023 JP 2023019424
(71) Applicant: Mitsubishi Heavy Industries, Ltd., Tokyo 100-8332 (JP)
(72) Inventor: SHIMBO, Yoichi, Tokyo 100-8332 (JP)
(74) Representative: Hoffmann Eitle
(86) International application number: PCT/JP2023/044945
(87) International publication number: WO 2024/166531

(57) **Abstract**

An object is to collectively provide a plurality of plant components forming a fluid transport system to a user. A purchase support device (1) includes: a condition entry support unit (31) configured to acquire a required function and a required specification as selection conditions; a standard system configuration generation unit (32) configured to determine a plurality of standard components forming the fluid transport system based on the selection conditions from a standard component database (21) and generate a standard system configuration diagram with the plurality of determined standard components being connected to each other; a system component selection unit (34) configured to select one or a plurality of supplier components corresponding to each of the standard components forming the standard system configuration diagram from a supplier component database (22); and a selection candidate generation unit (35) configured to generate at least one system configuration candidate, which is a combination of supplier components forming the fluid transport system, based on the plurality of selected supplier components and transmit the system configuration candidate to a client terminal.

## Description

### [Technical Field]

The present disclosure relates to a purchase support device, a purchase support method, and a purchase support program.

### [Background Art]

For example, when a potential purchaser (hereafter, which may be referred to as a "user") purchases a plant component, it is generally necessary for the user to go through steps described below with a supplier. Herein, an example of the potential purchaser may be a plant manufacturer or the like.

First, the potential purchaser prepares an order placement specification of a component, and presents the prepared general specification to a supplier to request a quotation from the supplier. The supplier prepares a written quotation based on the general specification and presents the prepared written quotation to the potential purchaser. The potential purchaser coordinates the specification and places an order with the supplier from which the potential purchaser requested the quotation.

**In** such a way, many steps are conventionally required before an order is placed, and time and effort are required in placing an order of a component. A potential purchaser can only obtain a quotation from the supplier from which the potential purchaser made an inquiry by itself. Thus, for example, even when there is a supplier that provides a similar component under better conditions (for example, a lower price, a shorter delivery time, a better service, or the like), there is inconvenience of being unable to reach the supplier. Furthermore, from a viewpoint on a supplier side, when a case is for a small lot and a low-price component, the sales or the profit is smaller for time and effort of preparing a quotation, which is not cost-effective. This may lead to a disadvantage for the potential purchaser. For example, a request may be handled later over other cases, a provided price may be quoted relatively higher, or the like.

A conventional system to reduce steps or time and effort for procurement of components includes a manufacturing outsourcing support device disclosed in Patent Literature 1. In response to receiving drawing data on a component from a manufacturer, the manufacturing outsourcing support device analyzes the received drawing data to determine a machinability of the component, requests a quotation from a plurality of machining companies that can machine the component, and responds with the quoted price to the manufacturer. In such away, the manufacturing outsourcing support device disclosed in Patent Literature 1 mediates transactions between a manufacturer and machining companies and thus can reduce burdens on both the parties for procurement of components.

Patent Literature 2 discloses a device that can automatically quote a price or a delivery time of a set of a plurality of components forming a mechanical device, so as to provide the quotation to the user.

### [Citation List]

### [Patent Literature]

[PTL 1]
   Japanese Patent No. 6462945
[PTL 2]
   Japanese Patent No. 6415492

### [Summary of Invention]

### [Technical Problem]

However, the devices disclosed in Patent Literatures 1 and 2 are systems dedicated to machined components and are not readily applicable to arrangement of plant components. Thus, for plant components, it is necessary to decide components to be purchased under consideration on parameters specific to fluid transport systems, such as a flow rate or a pressure loss, in addition to constraint conditions such as a design pressure, an operation pressure, a design temperature, an operation temperature, or the like. Thus, in the quotation of the whole fluid transport system formed of a plurality of plant components, it is not possible for the devices disclosed in Patent Literatures 1 and 2 to select components that meet all the constraint conditions or the like and to provide a set of these components to the user.

The present disclosure has been made in view of such circumstances and intends to provide a purchase support device, a purchase support method, and a purchase support program that can collectively provide a plurality of plant components forming a fluid transport system to a user.

### [Solution to Problem]

The purchase support device according to one aspect of the present disclosure is a purchase support device configured to support purchase of a fluid transport system including a plurality of plant components, and the purchase support device includes: a condition entry support unit configured to acquire, as selection conditions, a required function and a required specification related to a fluid transport system that a user wishes to purchase; a standard system configuration generation unit configured to determine a plurality of standard components forming the fluid transport system based on the selection conditions from a standard component database storing information on a plurality of standard components related to fluid transport systems and generate a standard system configuration diagram with the plurality of determined standard components being connected to each other; a system component selection unit configured to select one or a plurality of supplier components corresponding to each of the standard components forming the standard system configuration diagram from a supplier component database storing information on supplier components sold by a supplier; and a selection candidate generation unit configured to generate at least one system configuration candidate based on the plurality of selected supplier components and transmit the system configuration candidate to a client terminal, the system configuration candidate being a combination of supplier components forming the fluid transport system.

The purchase support device according to one aspect of the present disclosure is a purchase support device configured to support purchase of a fluid transport system including a plurality of components, and the purchase support device includes: a condition entry support unit configured to acquire, as selection conditions, a required function and a required specification and information on a transport start point and a transport end point related to a fluid transport system that a user wishes to purchase; and a system configuration generation unit configured to determine a supplier component forming the fluid transport system based on the acquired selection conditions, arrange the determined supplier component on a fluid transport path from a transport start point to a transport end point to generate a system configuration diagram, and provide a system configuration adjusting window to the user, the system configuration adjusting window allowing the user to adjust the generated system configuration diagram.

The purchase support device according to one aspect of the present disclosure is a purchase support device configured to support purchase of a fluid transport system including a plurality of plant components, and the purchase support device includes: a condition entry support unit configured to acquire, as selection conditions, a required function and a required specification related to a fluid transport system that a user wishes to purchase; a system configuration generation unit configured to determine supplier components forming the fluid transport system based on the acquired selection conditions and arrange the determined supplier components on a fluid transport path from a transport start point to a transport end point to generate a system configuration diagram; and a system selection unit configured to extract calculation blocks corresponding to the plurality of supplier components forming the fluid transport system from a fluid calculation block database storing a plurality of calculation blocks in which plant components and flow rate computing formulae are associated with each other, connect the extracted calculation blocks in accordance with a connection order to generate a calculation blockchain, and provide an input condition to the calculation blockchain to calculate an output condition of the fluid transport system.

The purchase support method according to one aspect of the present disclosure is a purchase support method for supporting purchase of a fluid transport system including a plurality of plant components, and a computer performs the purchase support method including: acquiring, as selection conditions, a required function and a required specification related to a fluid transport system that a user wishes to purchase; determining a plurality of standard components forming the fluid transport system based on the selection conditions from a standard component database storing information on a plurality of standard components related to fluid transport systems and generating a standard system configuration diagram with the plurality of determined standard components being connected to each other; selecting one or a plurality of supplier components corresponding to each of the standard components forming the standard system configuration diagram from a supplier component database storing information on supplier components sold by a supplier; and generating at least one system configuration candidate based on the plurality of selected supplier components and transmitting the system configuration candidate to a client terminal, the system configuration candidate being a combination of supplier components forming the fluid transport system.

The purchase support method according to one aspect of the present disclosure is a purchase support method for supporting purchase of a fluid transport system including a plurality of components, and a computer performs the purchase support method including: acquiring, as selection conditions, a required function and a required specification and information on a transport start point and a transport end point related to a fluid transport system that a user wishes to purchase; and determining a supplier component forming the fluid transport system based on the acquired selection conditions, arranging the determined supplier component on a fluid transport path from a transport start point to a transport end point to generate a system configuration diagram, and providing a system configuration adjusting window to the user, the system configuration adjusting window allowing the user to adjust the generated system configuration diagram.

The purchase support method according to one aspect of the present disclosure is a purchase support method for supporting purchase of a fluid transport system including a plurality of plant components, and a computer performs the purchase support method including: acquiring as selection conditions, a required function and a required specification related to a fluid transport system that a user wishes to purchase; determining supplier components forming the fluid transport system based on the acquired selection conditions and arranging the determined supplier components on a fluid transport path from a transport start point to a transport end point to generate a system configuration diagram; and extracting calculation blocks corresponding to the plurality of supplier components forming the fluid transport system from a fluid calculation block database storing a plurality of calculation blocks in which supplier components and flow rate computing formulae are associated with each other, connecting the extracted calculation blocks in accordance with a connection sequence to generate a calculation blockchain, and providing an input condition to the calculation blockchain to calculate an output condition of the fluid transport system.

The purchase support program according to one aspect of the present disclosure causes a computer to function as any one of the purchase support devices described above.

### [Advantageous Effects of Invention]

According to the purchase support device, the purchase support method, and the purchase support program of the present disclosure, an advantageous effect of ability of collectively presenting a plurality of plant components forming a fluid transport system to a user can be achieved.

### [Brief Description of Drawings]

[Fig. 1]

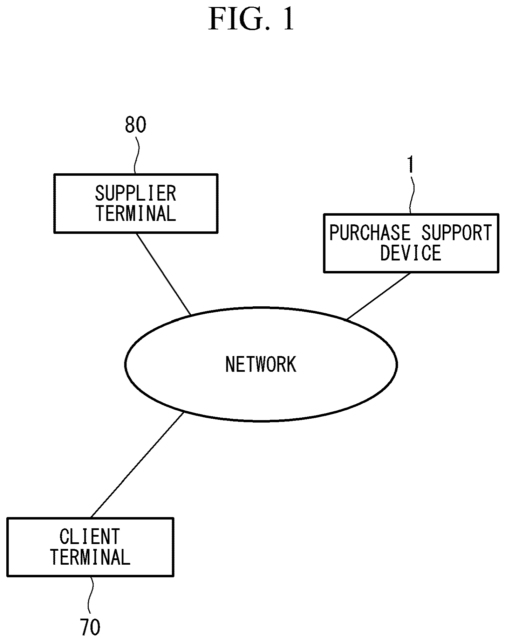

   Fig. 1 is a diagram illustrating a network configuration of a purchase support device according to one embodiment of the present disclosure.
[Fig. 2]

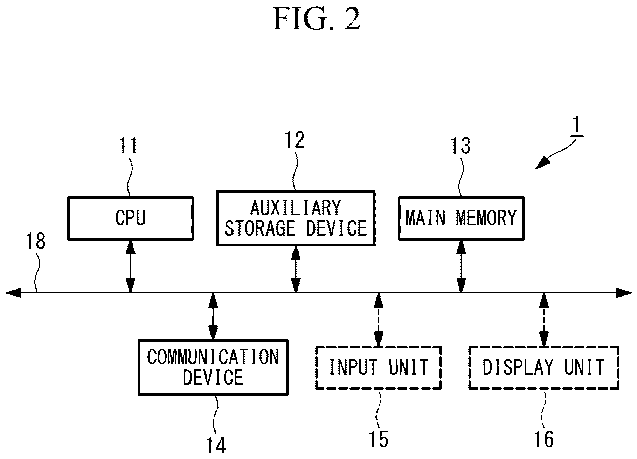

   Fig. 2 is a schematic configuration diagram illustrating an example of the hardware configuration of the purchase support device according to one embodiment of the present disclosure.
[Fig. 3]

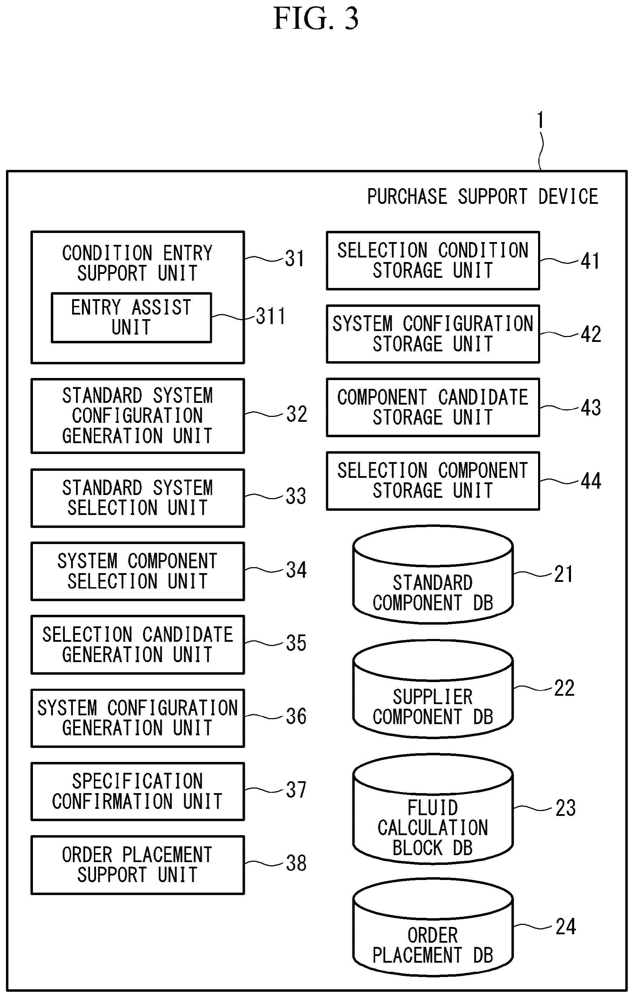

   Fig. 3 is a function configuration diagram illustrating an example of functions of the purchase support device according to one embodiment of the present disclosure.
[Fig. 4]

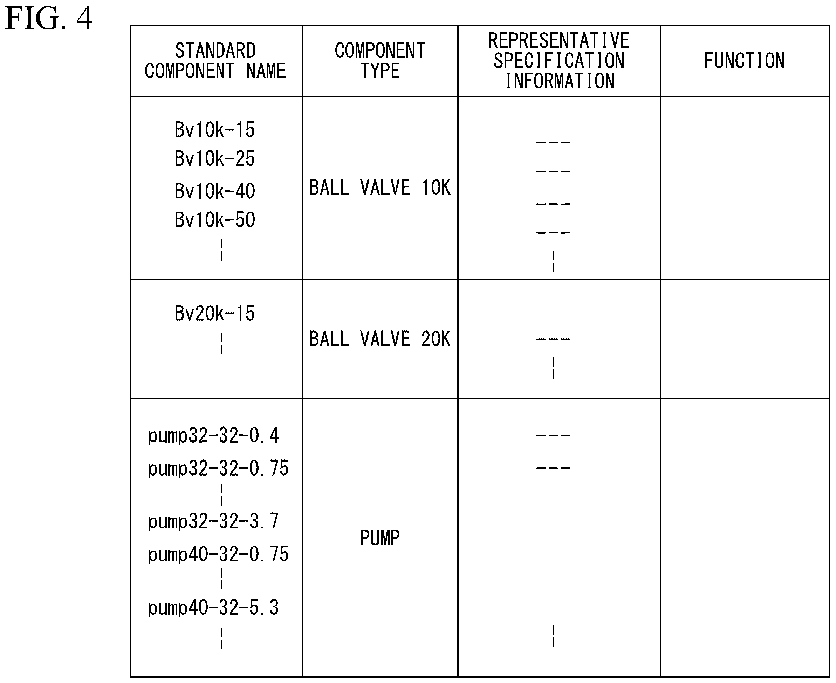

   Fig. 4 is a diagram illustrating an example of information stored in a standard component database according to one embodiment of the present disclosure.
[Fig. 5]

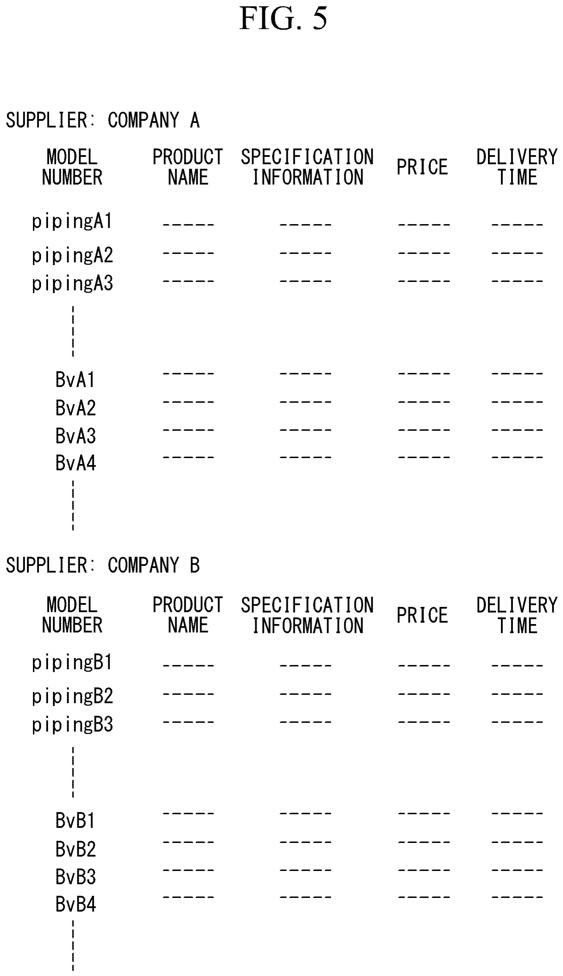

   Fig. 5 is a diagram illustrating an example of supplier component information stored in a supplier component database according to one embodiment of the present disclosure.
[Fig. 6]

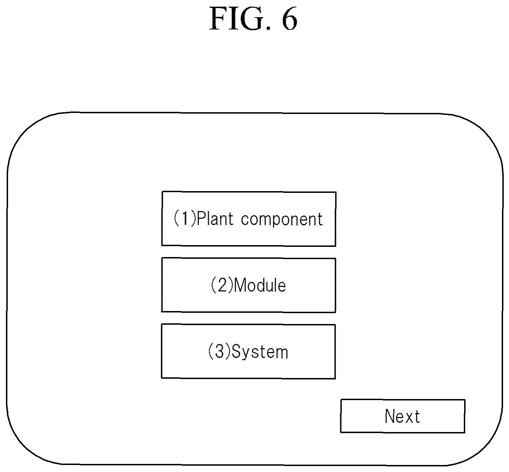

   Fig. 6 is a diagram illustrating an example of a condition entry window according to one embodiment of the present disclosure.
[Fig. 7]

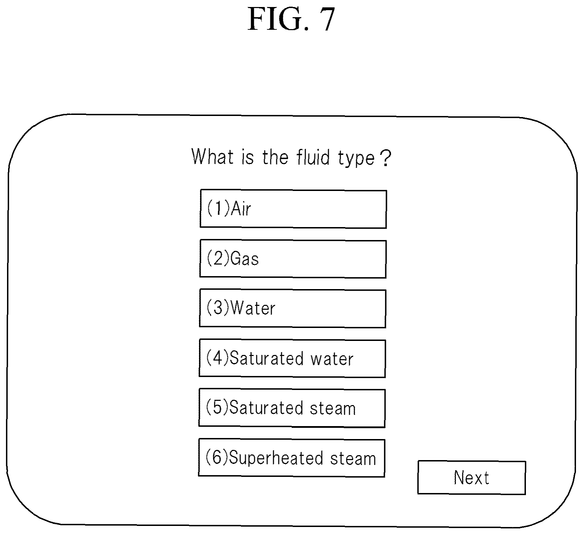

   Fig. 7 is a diagram illustrating an example of the condition entry window according to one embodiment of the present disclosure.
[Fig. 8]

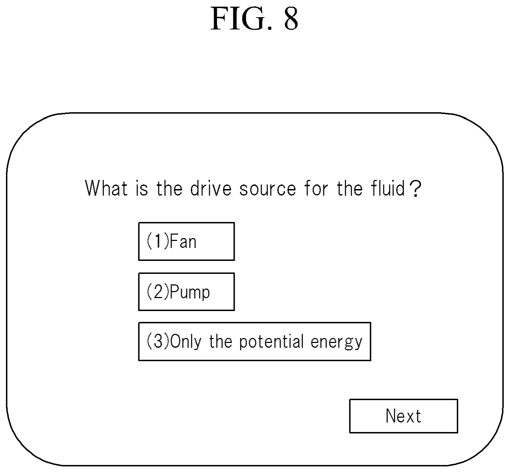

   Fig. 8 is a diagram illustrating an example of the condition entry window according to one embodiment of the present disclosure.
[Fig. 9]

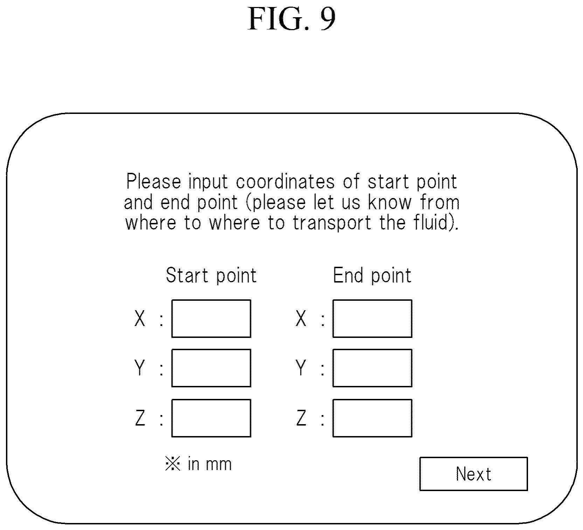

   Fig. 9 is a diagram illustrating an example of the condition entry window according to one embodiment of the present disclosure.
[Fig. 10]

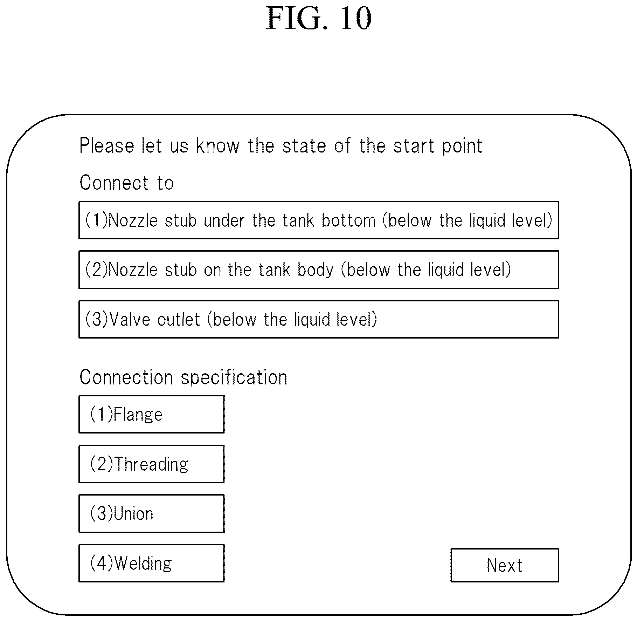

   Fig. 10 is a diagram illustrating an example of the condition entry window according to one embodiment of the present disclosure.
[Fig. 11]

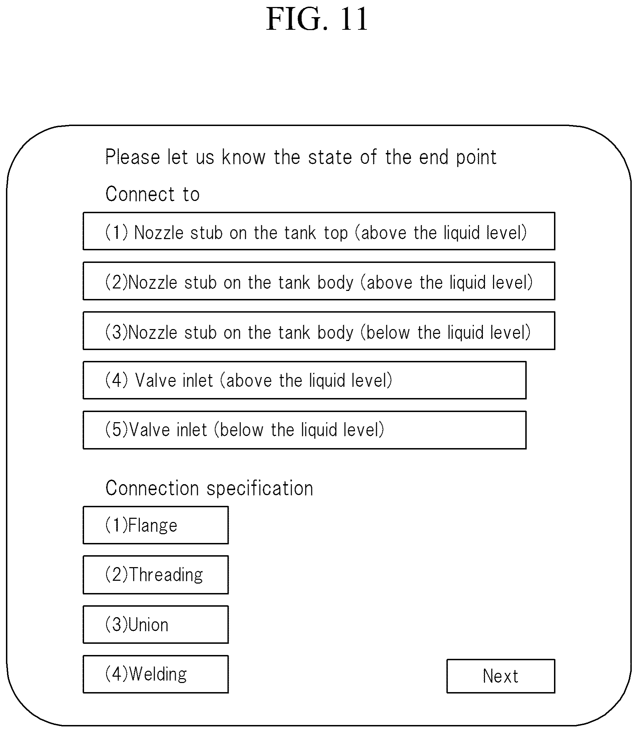

   Fig. 11 is a diagram illustrating an example of the condition entry window according to one embodiment of the present disclosure.
[Fig. 12]

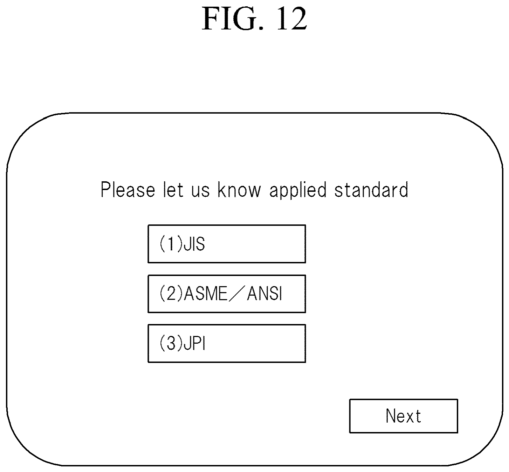

   Fig. 12 is a diagram illustrating an example of the condition entry window according to one embodiment of the present disclosure.
[Fig. 13]

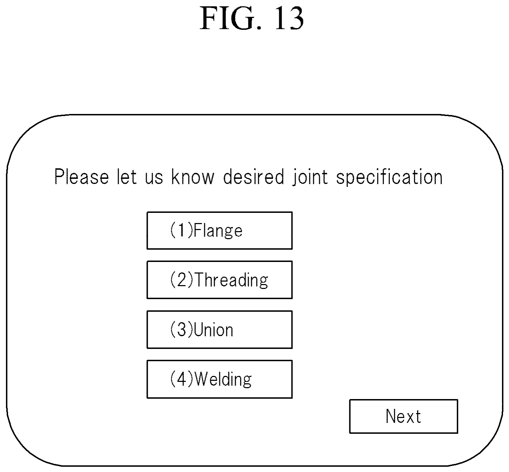

   Fig. 13 is a diagram illustrating an example of the condition entry window according to one embodiment of the present disclosure.
[Fig. 14]

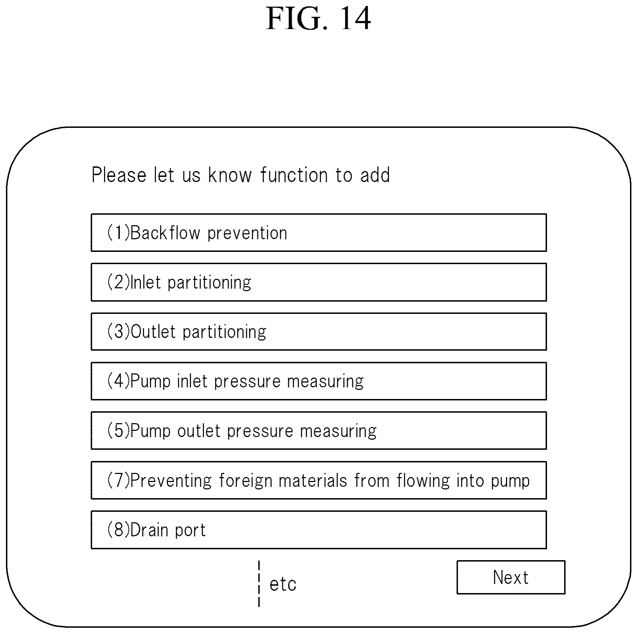

   Fig. 14 is a diagram illustrating an example of the condition entry window according to one embodiment of the present disclosure.
[Fig. 15]

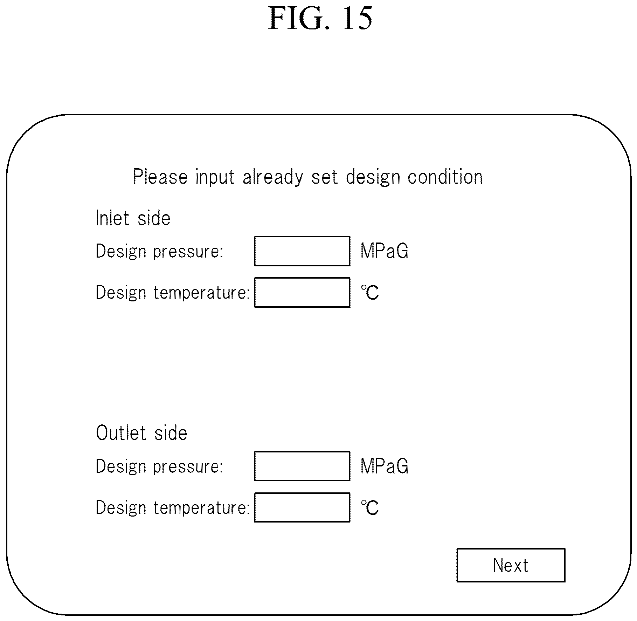

   Fig. 15 is a diagram illustrating an example of the condition entry window according to one embodiment of the present disclosure.
[Fig. 16]

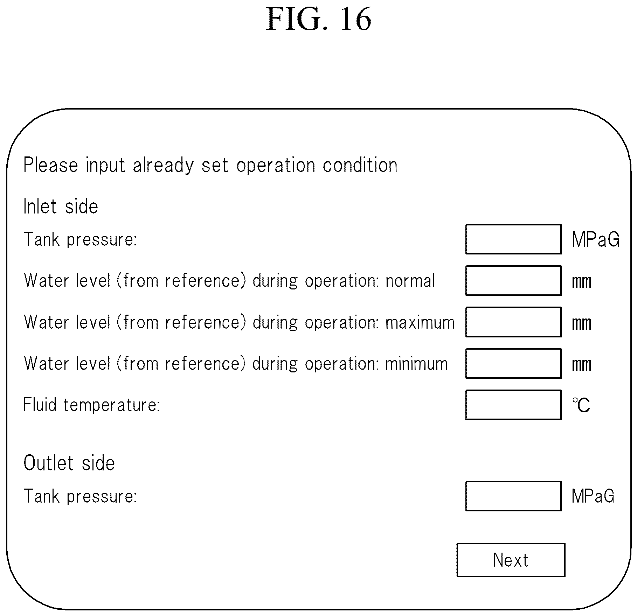

   Fig. 16 is a diagram illustrating an example of the condition entry window according to one embodiment of the present disclosure.
[Fig. 17]

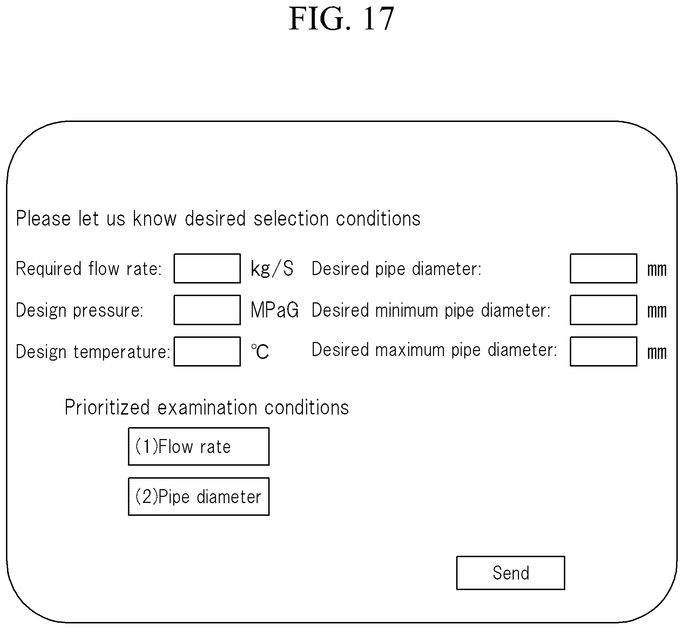

   Fig. 17 is a diagram illustrating an example of the condition entry window according to one embodiment of the present disclosure.
[Fig. 18]

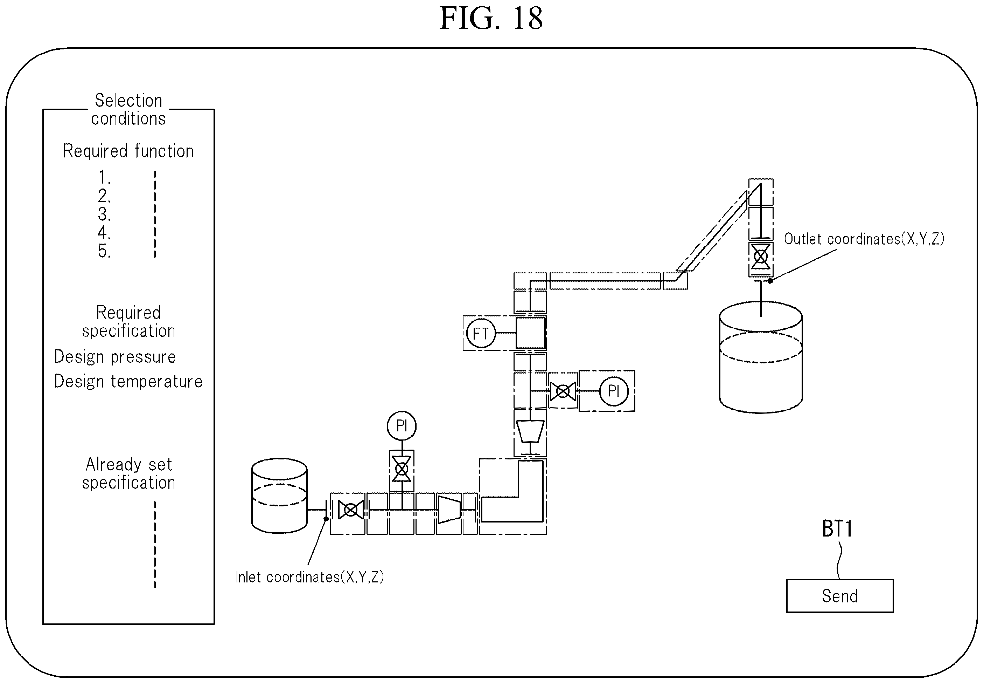

   Fig. 18 is a diagram illustrating an example of a standard system configuration adjusting window according to one embodiment of the present disclosure.
[Fig. 19]

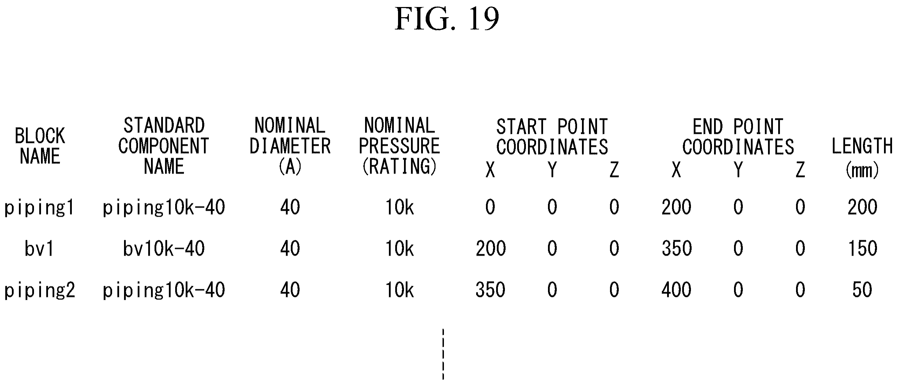

   Fig. 19 is a diagram illustrating an example of information stored in a system configuration storage unit according to one embodiment of the present disclosure.
[Fig. 20]

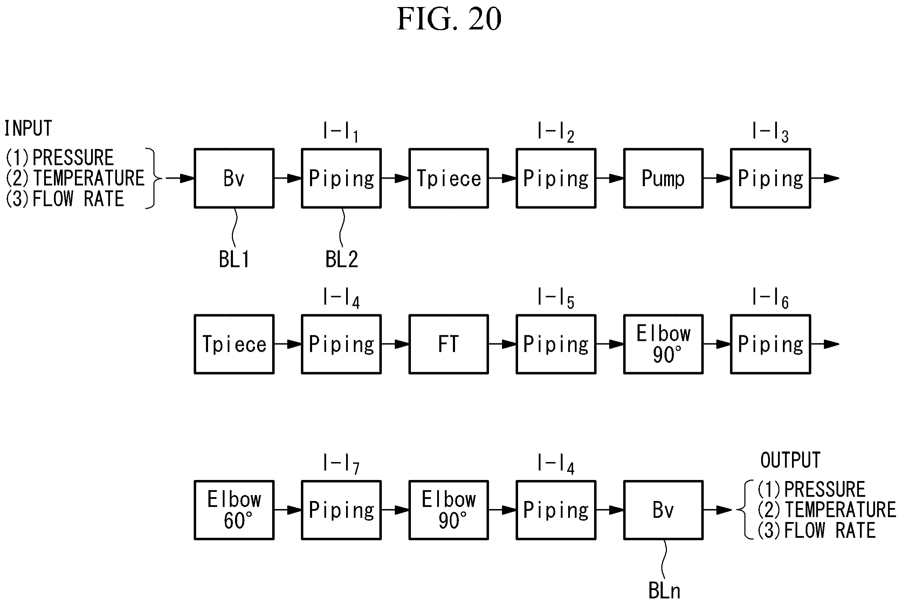

   Fig. 20 is a diagram illustrating an example of a calculation blockchain according to one embodiment of the present disclosure.
[Fig. 21]

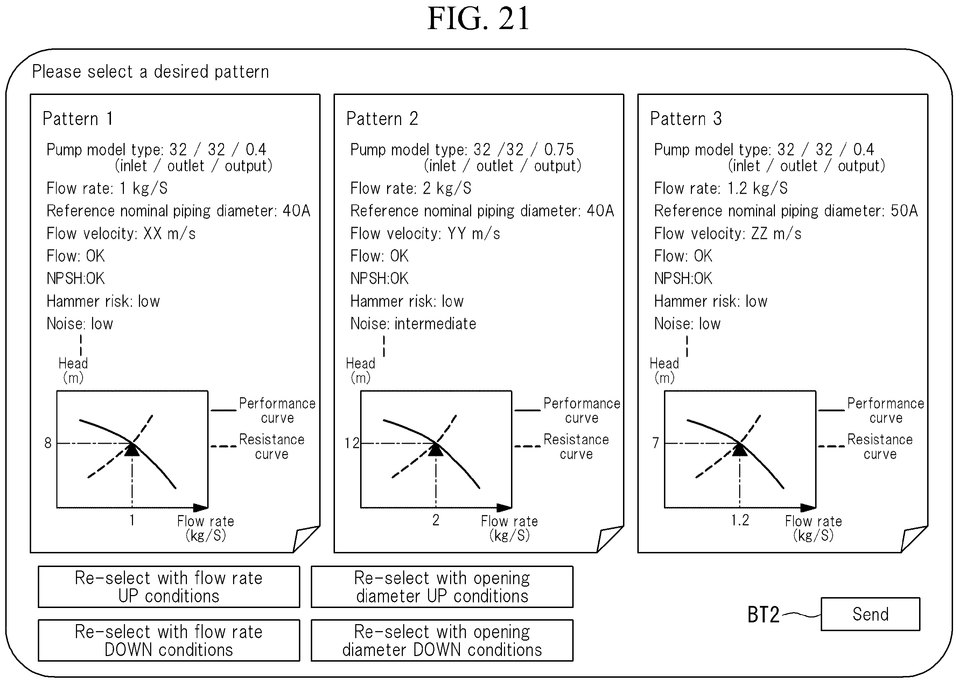

   Fig. 21 is a diagram illustrating an example of a standard system selection window according to one embodiment of the present disclosure.
[Fig. 22]

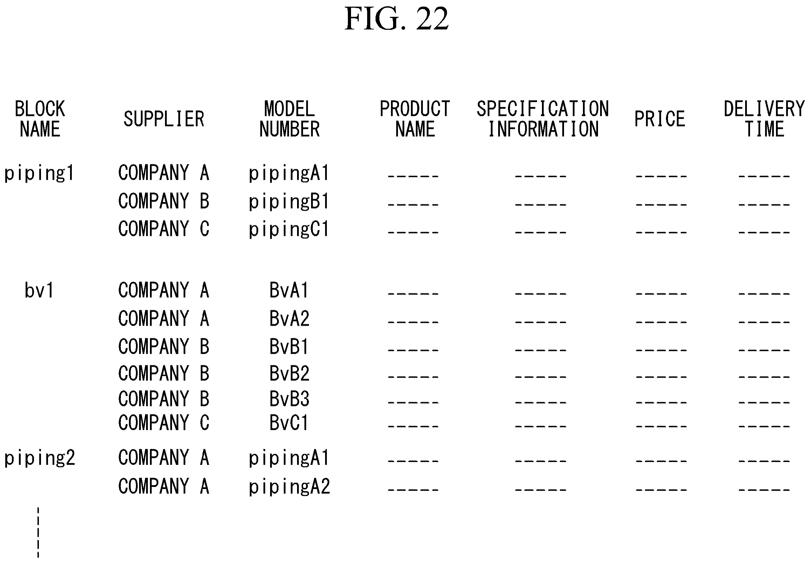

   Fig. 22 is a diagram illustrating an example of data stored in a component candidate storage unit according to one embodiment of the present disclosure.
[Fig. 23]

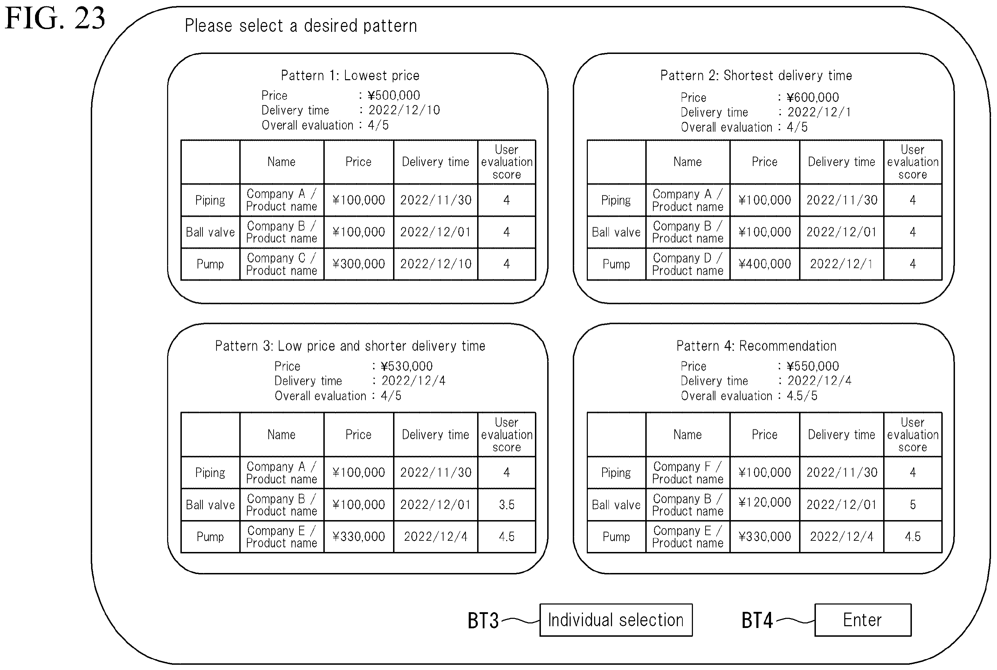

   Fig. 23 is a diagram illustrating an example of a comparison selection window according to one embodiment of the present disclosure.
[Fig. 24]

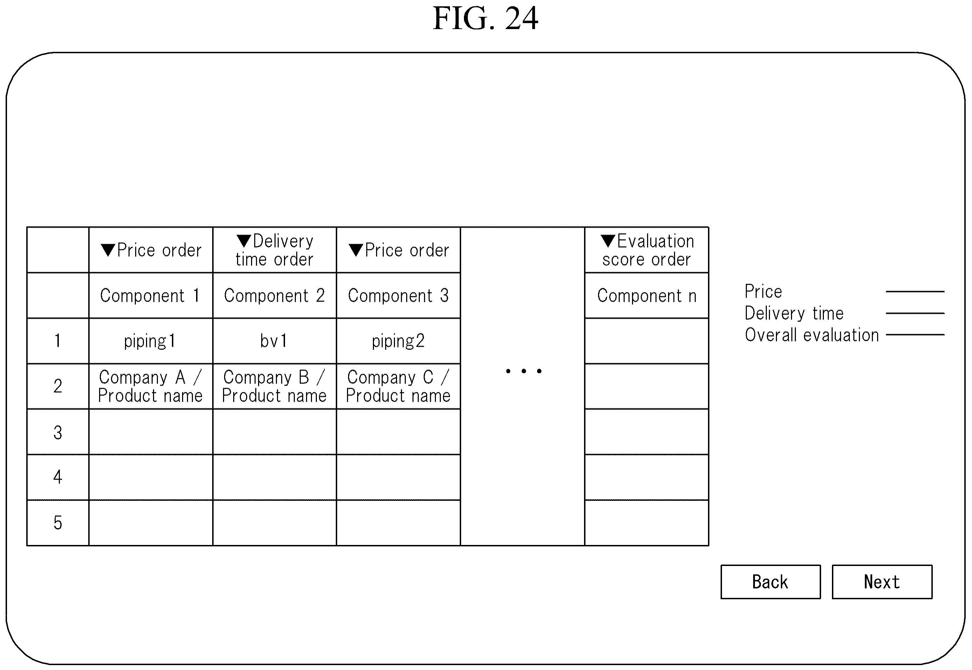

   Fig. 24 is a diagram illustrating an example of an individual selection window according to one embodiment of the present disclosure.
[Fig. 25]

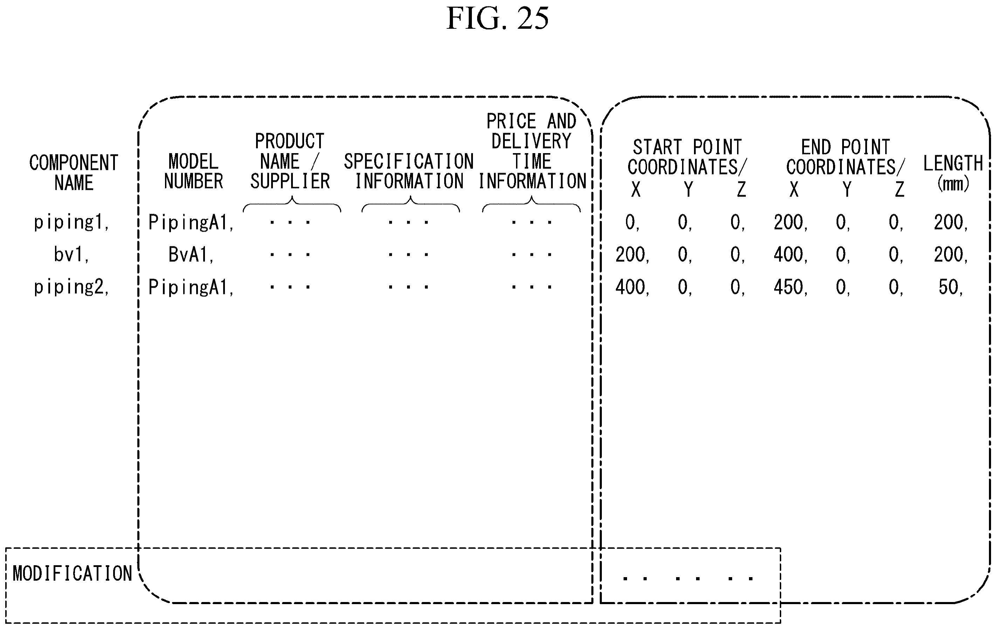

   Fig. 25 is a diagram illustrating an example of data stored in a selection component storage unit according to one embodiment of the present disclosure.
[Fig. 26]

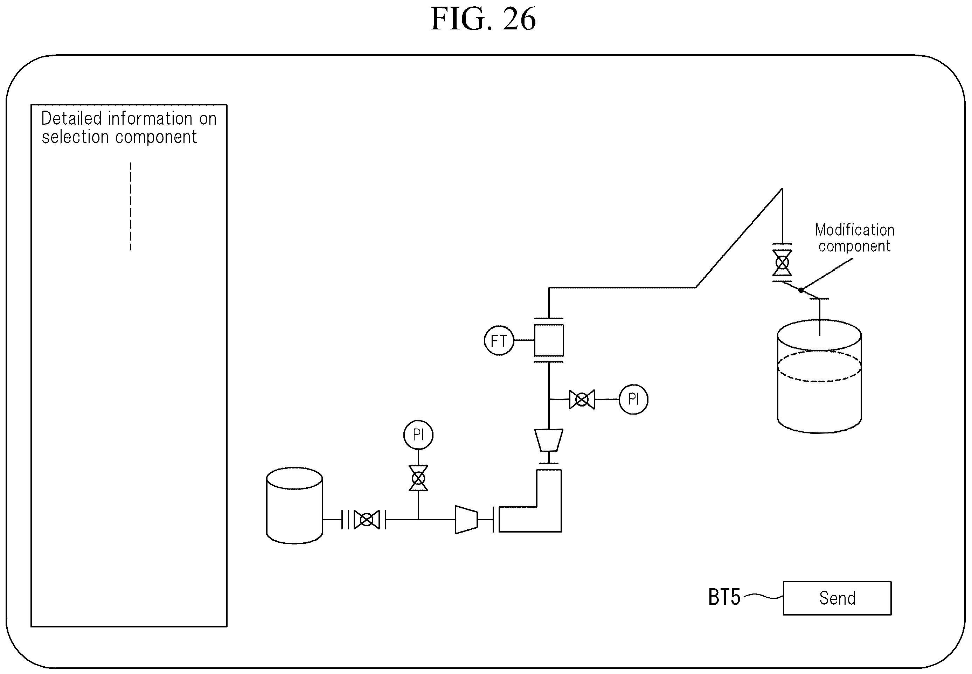

   Fig. 26 is a diagram illustrating an example of a system configuration adjusting window according to one embodiment of the present disclosure.
[Fig. 27]

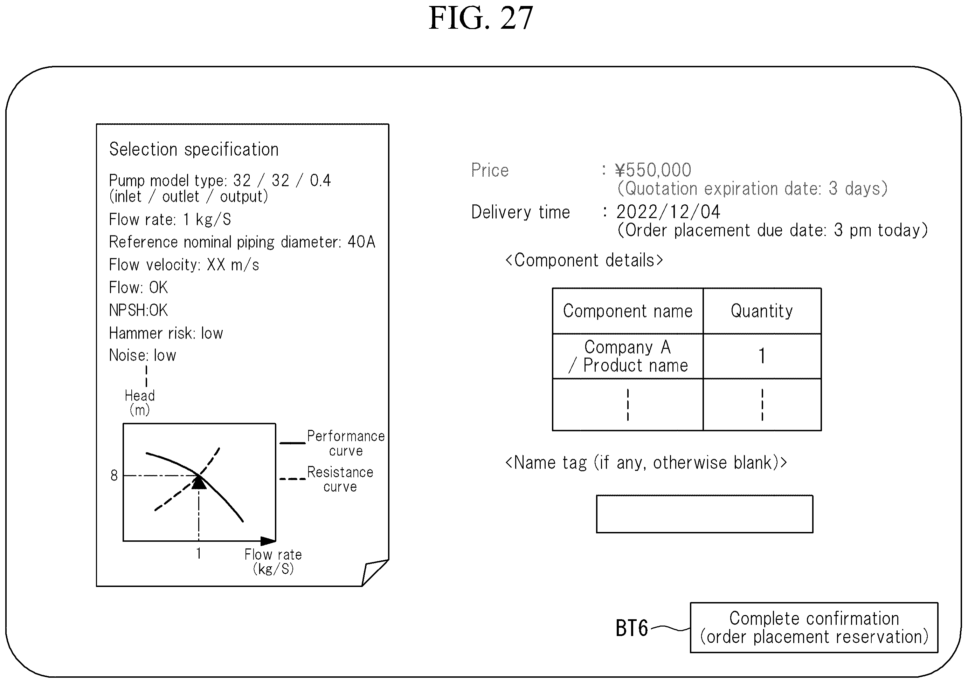

   Fig. 27 is a diagram illustrating an example of a final confirmation window according to one embodiment of the present disclosure.
[Fig. 28]

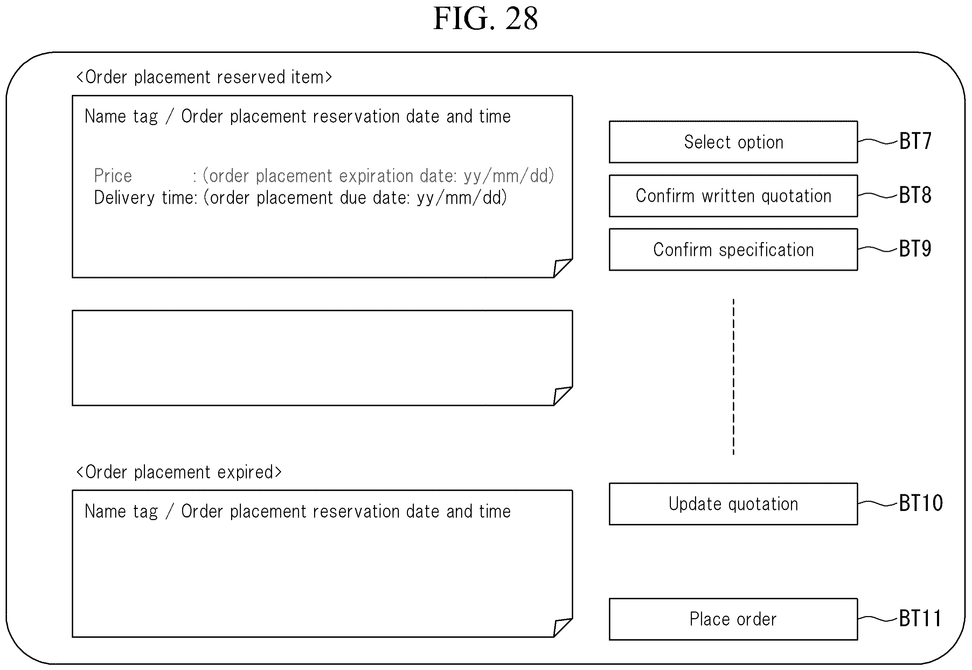

   Fig. 28 is a diagram illustrating an example of an order placement reservation window according to one embodiment of the present disclosure.
[Fig. 29]

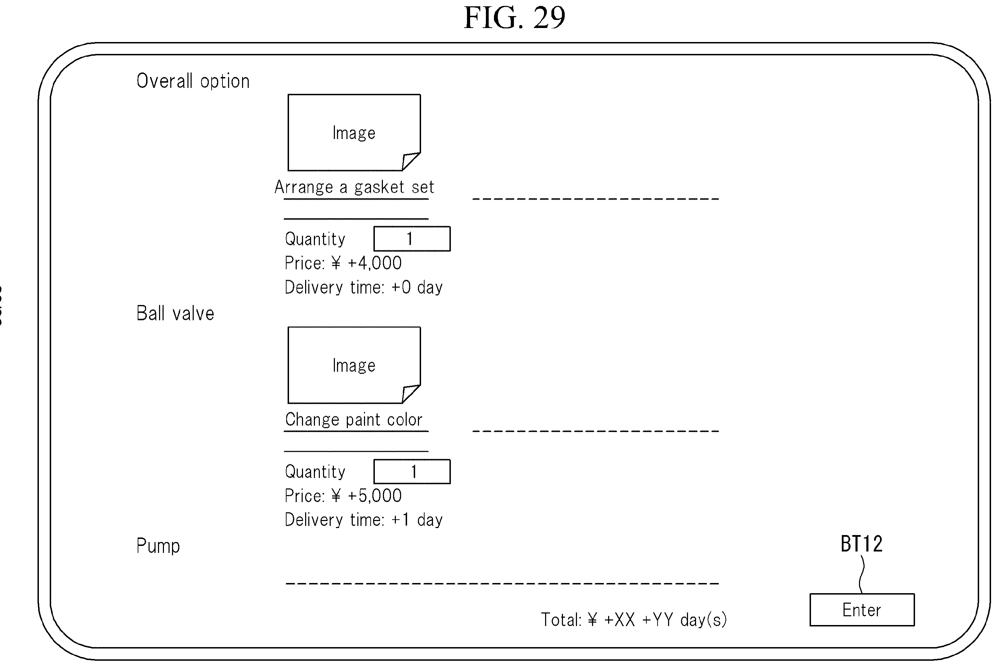

   Fig. 29 is a diagram illustrating an example of an option selection window according to one embodiment of the present disclosure.
[Fig. 30]

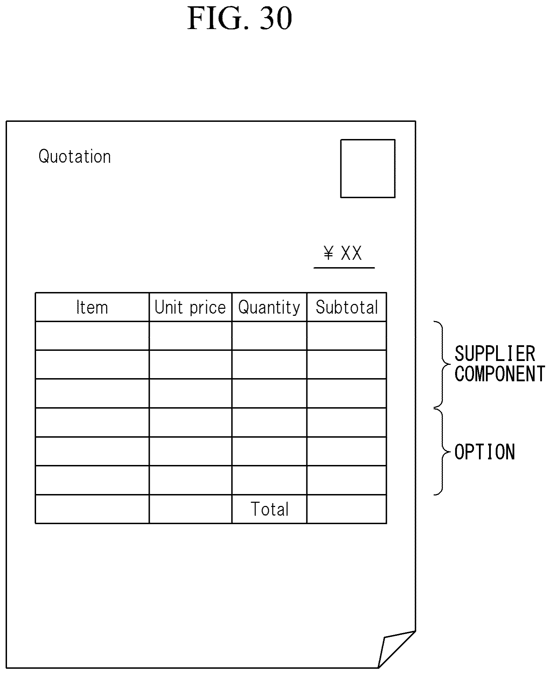

   Fig. 30 is a diagram illustrating an example of a written quotation confirmation window according to one embodiment of the present disclosure.
[Fig. 31]

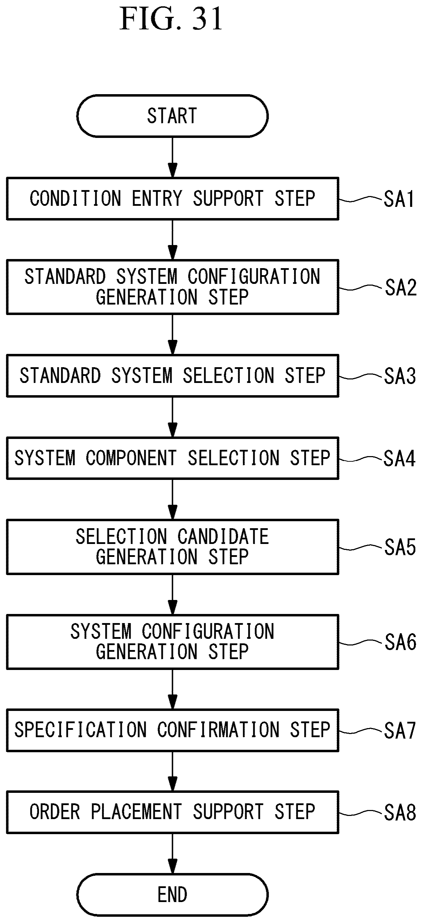

   Fig. 31 is a flowchart illustrating an example of a processing procedure of a purchase support method according to one embodiment of the present disclosure.
[Fig. 32]

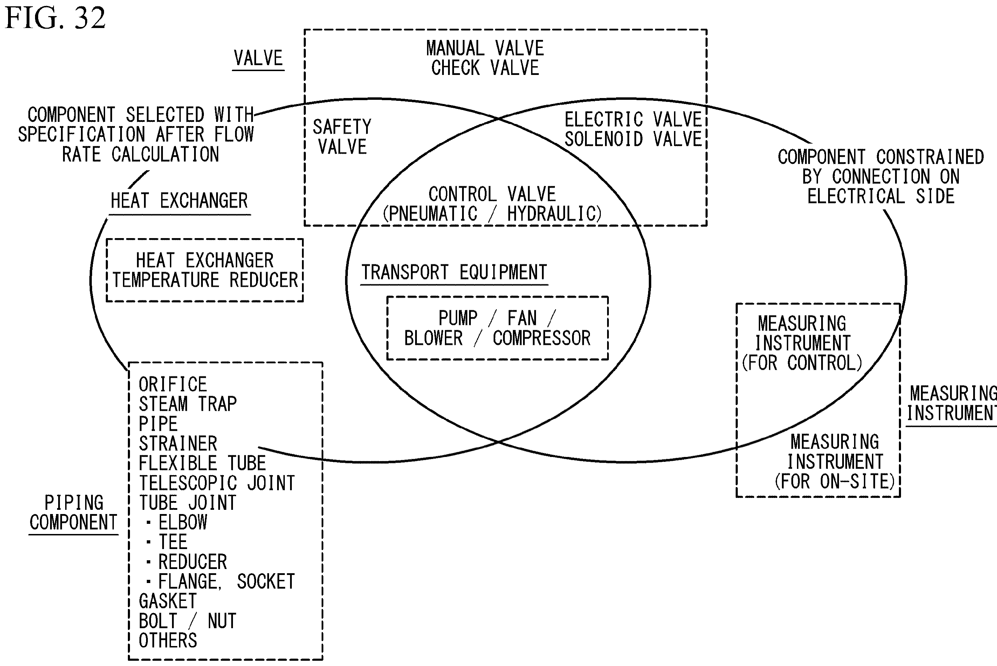

   Fig. 32 is a diagram illustrating relationships between plant components.

### [Description of Embodiments]

One embodiment of a purchase support device 1, a purchase support method, and a purchase support program according to the embodiment of the present disclosure will be described below with reference to the drawings.

The purchase support device 1 according to the present embodiment is a device that is suitable for purchasing a group of components (a set of components) forming a fluid transport system in plant engineering involving engineering with a fluid transport system, for example.

Herein, the "engineering with a fluid transport system" means, for example, performing planning, design, and procurement of a system that is incorporated in a plant and transports a medium such as a gas, a liquid, or a solid. The medium may be a gas-liquid mixture based medium (for example, a steam-drain mixture based medium), a gas-solid mixture based medium (for example, pulverized coal transported by air), a liquid-solid mixture based medium (for example, slurry), or the like.

The "plant component" means, for example, a fluid transfer element and equipment used in a fluid transport system. The fluid transfer element may be, for example, a pipe, a telescopic and flexible tube (a bellows, a flexible tube, or the like), a bent tube, an elbow, a joint, or a valve (a manual valve, an electric valve, a solenoid valve, a control valve, a safety valve, a check valve, or the like). The equipment may be, for example, a measuring instrument, transport equipment, a strainer, an accumulator, a steam trap, a temperature reducer, or the like. An example of the measuring instrument may be a pressure gauge, a thermometer, a flowmeter, or the like. An example of the transport equipment may be a pump, a fan, a blower, a compressor, a conveyer, or the like. Peripheral components may be heat-insulating equipment (heat-insulating member), a piping support member, a support stand for equipment, a steel frame, or the like. **In** a broader sense, it is also possible to target industry machines such as boilers, refrigerators, dehydrators, and dryers that accept a fluid and discharge a fluid.

Fig. 32 illustrates relationships between plant components.

In plant components, there are components whose specifications can be selected only after completion of design with consideration on operation of a plant, such as on a range of change in the flow rate. Such plant components may be, for example, piping components such as safety valves, control valves (including pneumatic valves and hydraulic valves), heat exchangers, temperature reducers, orifices, steam traps, or the like or transport equipment such as pumps, fans, blowers, compressors, or the like.

There are plant components that require electrical connection for power supply, measuring and control signals, or the like, and such plant components may be, for example, solenoid valves, electric valves, control valves (including pneumatic valves and hydraulic valves), transport equipment such as pumps, fans, blowers, compressors, conveyers, or measuring instruments.

The purchase support device 1 according to the present embodiment will be described below with reference to the drawings.

Fig. 1 is a diagram illustrating a network configuration of the purchase support device 1 according to the present embodiment. As illustrated in Fig. 1, the purchase support device 1 can be connected to a client terminal 70 and a supplier terminal 80 via a network and is configured so that information can be transmitted and received therebetween. An example of the network may be Wi-Fi, a mobile communication system (3G, 4G, 5G, 6G, LTE, or the like), a wireless local area network (LAN), a wired LAN, or the like.

Although a single client terminal 70 and a single supplier terminal 80 are illustrated as an example in Fig. 1, the number of client terminals 70 and the number of supplier terminals 80 connected to the purchase support device 1 are not limited to this example.

Although the purchase support device 1, the client terminal 70, and the supplier terminal 80 are connected to each other via the same network in Fig. 1, the connection is not limited to this example. For example, the network connected to the purchase support device 1 and the client terminal 70 and the network connected to the purchase support device 1 and the supplier terminal 80 may differ from each other.

Fig. 2 is a schematic configuration diagram illustrating an example of the hardware configuration of the purchase support device 1. The purchase support device 1 is a so-called server (computer) and, as illustrated in Fig. 2 for an example, includes, as the primary configuration, a CPU (processor) 11, an auxiliary storage device 12 for storing a program executed by the CPU 11 (for example, the purchase support program) or the like, a main memory 13 functioning as a work area during execution of each program, and a communication device 14 for connection to a network, and these devices are connected to each other via a bus 18. The purchase support device 1 may further include an input unit 15 such as a keyboard, a display unit 16, or the like. The auxiliary storage device 12 stores, for example, an OS for controlling the entire purchase support device 1, various drivers for operating peripherals as hardware, an application and various data or files for implementing the purchase support device 1, or the like. An example of the above auxiliary storage device 12 may be a semiconductor memory, a magnetic disk, a magneto-optical disk, or the like.

The client terminal 70 is an information processing device used by a user who wishes to purchase plant components, in particular in the present embodiment, a fluid transport system formed of a plurality of plant components. The client terminal 70 may be, for example, a desktop PC, a laptop PC, a tablet PC, a tablet terminal, a mobile phone terminal, a smartphone, or the like. Since the configuration of the client terminal 70 is well known, the detailed description thereof will be omitted. The client terminal 70 has a CPU, an auxiliary storage device, a main memory, a communication device, and an input unit in the same manner as the purchase support device 1 described above. Furthermore, the client terminal 70 has a display unit (a liquid crystal display, an organic EL display, or the like). Furthermore, the client terminal 70 may have a microphone or a speaker. The auxiliary storage device stores, for example, an OS for controlling the client terminal 70, such as Windows (registered trademark), iOS (registered trademark), Android (registered trademark), or the like, various drivers for operating the peripherals as hardware, an application and various data or files for implementing the function of the client terminal 70 described later, or the like.

The supplier terminal 80 is an information processing device used by a supplier that sells plant components. Herein, "supplier" means, for example, a company that manufactures and sells plant components. When a manufacturing company of plant components sells its own products through a trading company as an agent, a set of the manufacturing company and the trading company for the plant components is referred to as a "supplier".

The supplier terminal 80 may be, for example, a desktop PC, a laptop PC, a tablet PC, a tablet terminal, a mobile phone terminal, a smartphone, or the like. Since the configuration of the supplier terminal 80 is well known, the detailed description thereof will be omitted. The supplier terminal 80 has a CPU, an auxiliary storage device, a main memory, a communication device, and an input unit in the same manner as the purchase support device 1 described above. Furthermore, the supplier terminal 80 has a display unit (a liquid crystal display, an organic EL display, or the like). Furthermore, the supplier terminal 80 may have a microphone or a speaker. The auxiliary storage device stores, for example, an OS for controlling the entire supplier terminal 80, such as Windows (registered trademark), iOS (registered trademark), Android (registered trademark), or the like, various drivers for operating the peripherals as hardware, an application and various data or files for implementing the function of the supplier terminal 80 described later, or the like.

Next, functions of the purchase support device 1 according to the present embodiment will be described. Fig. 3 is a function diagram illustrating an example of functions of the purchase support device 1 according to the present embodiment. A series of processes for implementing each function illustrated below are stored in the auxiliary storage device 12 of the purchase support device 1 as a program (for example, the purchase support program) as an example, and various functions are implemented when the CPU 11 loads this program into the main memory 13 and executes the program. The program may be employed as a form in which the program is installed in advance in the auxiliary storage device 12 of the purchase support device 1, a form in which the program is provided stored in a computer readable storage medium, a form in which the program is delivered via a wired or wireless communication scheme, or the like. The computer readable storage medium may be a magnetic disk, a magneto-optical disk, a CD-ROM, a DVD-ROM, a semiconductor memory, or the like.

As illustrated in Fig. 3, the purchase support device 1 may include a standard component database 21 and a supplier component database 22. The purchase support device 1 may include a fluid calculation block database 23 and an order placement database 24. The purchase support device 1 may include a condition entry support unit 31, a standard system configuration generation unit 32, a standard system selection unit 33, a system component selection unit 34, a selection candidate generation unit 35, a system configuration generation unit 36, a specification confirmation unit 37, and an order placement support unit 38. The purchase support device 1 may include a selection condition storage unit 41, a system configuration storage unit 42, a component candidate storage unit 43, and a selection component storage unit 44 as storage areas for storing various data in selection of system components. Each unit will be described below. For easier understanding, a case where a fluid transport system for delivering water from an existing (already installed) tank to another existing tank is newly installed will be described as an example here; however, the embodiment is not limited thereto, and the same handling can apply for any fluids and any equipment or components through which the fluid flows in and out.

### [Standard component database 21]

The standard component database 21 stores information on a plurality of standard components related to fluid transport systems. For example, for each plant component, representative specification information, which is information on a representative specification, and the function of the component are stored in association with each other in the standard component database 21. For example, the representative specification information is determined in advance based on the specification of each plant component provided by each supplier. For example, in a case of a pump, the representative specification is determined in advance based on opening diameters (inlet/outlet) and motor power.

Fig. 4 illustrates an example of information stored in the standard component database 21 according to the present embodiment. As illustrated in Fig. 4, in the standard component database 21, standard component names, component types, representative specification information, and functions are registered in association with each other. While the component type and the representative specification information are separately provided here, the component type may be incorporated in the representative specification information to be a part of the representative specification information.

Herein, a "function" corresponds to a "required function" input via the condition entry support unit 31 or the like described later. A standard component associated with a "function" corresponding to a "required function" selected by the user via the condition entry support unit 31 described alter will be selected as a configuration component of a fluid transport system.

In the standard component database 21, for enabling easier extraction of the above information, a method of using a standard component name as a key (a name serving as a mark), for example, and saving and processing representative specification information in association with the key may be taken (hereafter, referred to as a "map format").

### [Supplier component database 22]

The supplier component database 22 stores information on supplier components sold by suppliers. For example, for each supplier, model numbers and specification data of plant components sold by the supplier are stored in association with each other in the supplier component database 22. Information on product names, prices, and delivery times may be further associated with model numbers of plant components. Option information may be further associated with model numbers of the plant components.

Fig. 5 illustrates an example of supplier component information stored in the supplier component database 22 according to the present embodiment. As illustrated in Fig. 5, in the supplier component database 22, model numbers, product names, specification information, prices, and delivery times are registered in association with each other on a supplier basis. In the supplier component database 22, data management may be performed on the above information in the map format, for example.

The information on prices and delivery times can be updated in any time by each supplier. This makes it possible to prepare a written quotation by using the latest data. This makes it possible to provide a reliable written quotation to the user. With respect to the price, expenses required for shipping of products or the like may be registered in addition to the prices of the plant components.

The option information may represent, for example, an optional product (such as consumables, a special tool), dispatchment of an instructor for installation, operation adjustment in test run, a technical support service such as trouble shooting, or a specification upgrade service (for example, building-up against corrosion, high-grade coating, additional inspection, additional submission of drawings, or the like). Detailed information may be registered for the option information in association with various options. For example, the detailed information on spare components may be a delivery time, a price, a replacement time, or the like. The detailed information on the technical support or the option service may be a time to provide the service, a price, a feature, an advantage, a notice, or the like.

### [Fluid calculation block database 23]

The fluid calculation block database 23 stores a plurality of calculation blocks in which standard components (for example, standard component names) and typical computing formulae are associated with each other. **In** the fluid calculation block database 23, a plurality of calculation blocks in which supplier components provided by each supplier (for example, supplier model numbers) and computing formulae unique to suppliers are stored in association with each other.

In each calculation block, for example, a pressure loss computing formula for calculating an outlet pressure from a fluid pressure occurring at a component inlet is registered.

### [Order placement database 24]

The order placement database 24 stores information on order placements on a user basis, for example. The information on order placements may be the past order placement history, the current order placement reservation information, the order placement status, or the like. By checking the content of the order placement database 24, it is possible to know a plant component purchased or to be purchased by each user.

### [Condition entry support unit 31]

The condition entry support unit 31 acquires, as selection conditions, a required specification and a required function related to a fluid transport system that the user wishes to purchase. For example, the required specification includes at least any one of an inlet-side design temperature, an inlet-side design pressure, an outlet-side design temperature, or an output-side design temperature. The required specification may include already set operation conditions. The already set operation condition may be, for example, at least one of the tank pressure, the water level, or the fluid temperature on the inlet side and the tank pressure on the outlet side.

The required function is a function that the user intends to provide to a fluid transport system and may be, as an example, a backflow preventing function, an inlet partitioning function, an outlet partitioning function, a pump inlet pressure measuring function, a pump outlet pressure measuring function, a flow rate measuring function, a function of preventing foreign materials from flowing into a pump, a drain port function, or the like.

Furthermore, the selection condition may include at least any one of a type of a fluid to be transported, a drive source for a fluid, information on a transport start point and a transport end point of a fluid, an applied standard, or a piping joint specification. The selection condition may include a desired selection condition of a plant component and a prioritized examination condition. For example, an example of a choice of the prioritized examination condition may be a flow rate or a piping diameter. While a larger piping diameter has advantages of a smaller pressure loss during a fluid flowing and a smaller loss during operation, such a larger piping diameter has disadvantages of a larger material cost and also a larger required space. When a fluid transport system is planned, it is required to perform overall evaluation on the performance during operation, the material cost, the spatial allowability, the delivery time, or the like and determine an optimal solution. The present desired selection condition and prioritized examination condition are intended to early obtain an examination result that is close to the condition desired by the user.

The type of a fluid may be, for example, air, gas, water, saturated water, saturated steam, superheated steam, or the like. The drive source for a fluid may be, for example, a fan, a pump, potential energy, or the like.

The information on a transport start point of a fluid may be, for example, start point coordinates, a connecting counterpart, or a connection specification. The connecting counterpart when a liquid is transported may be, for example, a nozzle stub under a tank bottom (below the liquid level), a nozzle stub on a tank body (below the liquid level), or a valve outlet (below the liquid level). The connection specification may be, for example, flange connection, screwing connection, union connection, or welding connection.

The information on a transport end point of a fluid may be, for example, end point coordinates, a connecting counterpart, or a connection specification. The connecting counterpart when a liquid is transported may be, for example, a nozzle stub on a tank top (above the liquid level), a nozzle stub on a tank body (above the liquid level), a nozzle stub on a tank body (below the liquid level), a valve inlet (above the liquid level), or a valve inlet (below the liquid level). The connection specification may be, for example, flange connection, screwing connection, union connection, or welding connection.

The applied standard may be, for example, JIS, ASME, ANSI, JPI, or the like.

The joint specification may be, for example, flange joint, screwing joint, union joint, or welding joint.

The desired selection condition of a plant component may be, for example, a required flow rate, a design pressure, a design temperature, a desired piping diameter, a desired minimum piping diameter, or a desired maximum piping diameter.

The prioritized examination condition may be, for example, a flow rate or a piping diameter.

The selection condition may include the latest acceptable delivery time, the highest acceptable price, or various information about delivery or the like, such as a desired destination, a package specification, or a transportation method. **In** such a way, when the latest acceptable delivery time or the highest acceptable price is input as a selection condition, delivery times or prices that do not meet the user's wish can be excluded. This can improve the user convenience and reduce a computational processing load at the purchase support device 1.

For example, the condition entry support unit 31 generates window data for causing the condition entry window used for entry of the above selection conditions to be displayed on the client terminal 70 and transmits the window data to the client terminal 70. For example, the entry of the selection condition may be performed in an interactive way. Entry can be facilitated using a figure or the like so that it is possible for even an inexperienced engineer to easily make an entry or it is easy to know the overview.

Fig. 6 to Fig. 17 are diagrams each illustrating an example of an interactive condition entry window generated by the condition entry support unit 31. The condition entry support unit 31 causes the condition entry windows illustrated in Fig. 6 to Fig. 17 to be displayed sequentially on the client terminal 70, thereby allows the user to input required conditions, and acquires information required for selecting plant components forming a fluid transport system.

Fig. 6 represents a condition entry window used for selection of an item to be purchased, Fig. 7 represents a condition entry window used for selection of a fluid type, Fig. 8 represents a condition entry window used for selection of a drive source for a fluid, Fig. 9 represents a condition entry window used for entry of coordinates of a transport start point and a transport end point of a fluid, Fig. 10 represents a condition entry window used for selection of a connecting counterpart and a connection specification of a transport start point of a fluid, Fig. 11 represents a condition entry window used for selection of a connecting counterpart and a connection specification of a transport end point of a fluid, Fig. 12 represents a condition entry window used for selection of an applied standard, Fig. 13 is a condition entry window used for selection of a joint specification, Fig. 14 represents a condition entry window used for selection of an additional function (required function), Fig. 15 represents a condition entry window used for entry of already set design conditions, Fig. 16 represents a condition entry window used for entry of already set operation conditions, and Fig. 17 represents a condition entry window used for entry of desired selection conditions and prioritized examination conditions. For easier understanding, a case where a fluid transport system for delivering water from an existing (already installed) tank to another existing tank is newly installed has been described as an example here. Thus, already set design conditions and already set operation conditions are input in Fig. 15 and Fig. 16. However, if a new tank is being installed, newly set design conditions and newly set operation conditions may be input.

For entry of the selection conditions, a plurality of entry modes may be provided. For example, a plurality of entry modes may be presented to the user to allow the user to select any of these entry modes. Further, the condition entry support unit 31 may generate the condition entry window in accordance with the entry mode selected by the user and transmit the condition entry window to the client terminal 70.

An example of the entry modes may be a detailed entry mode, a simple entry mode, a model number entry mode, or the like. The detailed entry mode is, in general, a mode for inputting all the conditions required when a supplier selects a component. This mode is intended for users who are familiar with engineering in fluid transport systems. The simple entry mode is a mode intended for unfamiliar users and provided with entry items narrowed down to primary items. For example, in this mode, some of the conditions to be input in the detailed entry mode are omitted. The model number entry mode is a mode for inputting a supplier name or a model number, targeting users who wish to purchase the same plant component as the already installed plant component or users who have researched supplier catalogs or the like in advance and decided a desired model number.

As discussed above, a plurality of entry modes are provided and configured for the user to select a desired entry mode, and this makes it possible to provide services in accordance with user's engineering capabilities and needs.

### [Entry assist unit]

The condition entry support unit 31 may include an entry assist unit 311 (see Fig. 3), for example. The entry assist unit 311 preliminarily inputs one or more selection conditions that have not been input by the user out of a plurality of selection conditions based on the past accumulated data or the initial value set in advance.

For example, the entry assist unit 311 has initial values for design conditions or operation conditions in advance and preliminarily inputs these initial values when no selection condition is input for the design condition or the operation condition. Instead of the initial values, representative values based on the past record values or the like may be preliminarily input.

Furthermore, the entry assist unit 311 may pose a question to the user in accordance with a predetermined question flow and allow the user to input a missing selection condition in an interactive way through which the user answers to the question. When preliminary input is performed by the entry assist unit 311, the preliminarily input condition may be presented to the user to allow the user to check whether the preliminarily input condition is not out of user's expectation.

For example, plant components have not only constraint conditions linked with the components such as the shape, the strength, or the like but also constraint conditions for a fluid flowing inside. Thus, a certain level of experience is required to select suitable components. Thus, inexperienced users do not know what kind of conditions to be set, and it is sometimes difficult to set conditions by themselves. **In** such a case, by providing the entry assist unit 311 to support user's entry, it is even possible for users having limited experience of engineering in fluid transport systems to input suitable conditions required in arranging plant components.

### [Selection condition storage unit 41]

The selection conditions such as the required specification and the required function acquired by the condition entry support unit 31 are stored in the selection condition storage unit 41. For example, the selection condition may be stored in the map format. For example, conditions input by the user are stored for the selection conditions in association with each main item such as an inlet condition, an outlet condition, a required function, a design pressure and temperature, or a required specification. New information may be added to these selection conditions by execution of predetermined computation based on conditions acquired from the user. For example, in selection of a plant component, a nominal pressure (temperature-pressure rating) is calculated from a set pressure and a set temperature, and component selection is performed using the nominal pressure. Thus, the selection condition may include a nominal pressure (temperature-pressure rating) based on a set pressure and a set temperature acquired from the client terminal 70.

### [Standard system configuration generation unit 32]

The standard system configuration generation unit 32 determines a plurality of standard components forming a fluid transport system from the standard component database 21 based on the selection condition stored in the selection condition storage unit 41 and generates a standard system configuration diagram with the plurality of determined standard components being connected to each other. Specifically, the standard system configuration generation unit 32 arranges the plurality of determined standard components on a fluid transport path from a transport start point to a transport end point and thereby generates a standard system configuration diagram, which is a system configuration diagram of the fluid transport system.

Specifically, the standard system configuration generation unit 32 acquires corresponding standard components from the standard component database 21 based on information on selection conditions (for example, a required function, a piping diameter, a rating, a connection form). The standard system configuration generation unit 32 then arranges the acquired standard components sequentially on the fluid transport path and thereby generates a standard system configuration diagram. At this time, the fluid transport path is generated based on start point coordinates, end point coordinates, an already set specification, and the like and connected by piping based on the value input as the desired piping diameter from the start point to the end point.

Once generating a standard system configuration diagram, the standard system configuration generation unit 32 generates a standard system configuration adjusting window including the standard system configuration diagram and causes the window data thereof to be displayed on the display unit of the client terminal 70. Fig. 18 is a diagram illustrating an example of the standard system configuration adjusting window. The standard system configuration adjusting window displays a standard system configuration diagram generated based on selection conditions, and in addition thereto, displays information on required functions, required specifications, or already set specifications or the like input as the selection conditions for this standard system configuration diagram. **In** the standard system configuration diagram illustrated in Fig. 18, respective blocks surrounded by dash-dot lines are component blocks corresponding to each standard component.

In this standard system configuration adjusting window, the standard system configuration diagram is configured such that the user is able to perform at least one of addition of piping, a change of the route, a change of the positions and the arrangement order of component blocks, or addition and deletion of a required function, and the like. While illustrated as a two-dimensional system configuration diagram in Fig. 18, the window may be displayed as a three-dimensional system configuration diagram such as an isometric diagram with isometric projection or 3D display, for example.

On this system configuration adjusting window, the user renders a desired system configuration diagram by performing operation of moving a component block, changing the dimension of a pipe connecting component blocks to each other, or the like, and upon completion of the rendering, the user presses a send button BT1. Accordingly, information on the system configuration diagram finalized by the user is transmitted to the purchase support device 1.

When drawings of peripheral components around which the fluid transport system is installed (for example, two-dimensional CAD data, three-dimensional CAD data, or the like) or the like are provided to the purchase support device 1, these peripheral components or the like may be included in and displayed with a standard system configuration diagram as the background. In such a way, peripheral components or the like are displayed together as the background, and it is thus possible to arrange standard components at suitable positions in consideration of arrangement or the like with the peripheral components.

For example, some plant components may have constraints on the upstream and downstream facility configuration or straight piping lengths. For example, orifice type flow meters have constraints that a certain length of straight piping lengths needs to be ensured upstream and downstream in order to maintain a measurement error within the standard. When different types of measuring instruments are arranged, there is desirable order of installation. For example, since the measurement point of a thermometer is inserted into a fluid, this causes a disturbance of a fluid flow and may affect a measurement result of the pressure or the flow rate. Thus, there are constraints that a thermometer needs to be installed downstream of a pressure meter or a flow meter or the like. **In** electromagnetic type flow meters, the flow rate measuring part is required to be always filled with a fluid, and thus there is a constraint on the piping route. **In** safety valves, when the pressure loss of the wake is excessively high; in other words, when the pipe is excessively thin or excessively long, a planned blowout amount is not ensured, and thus there is a constraint on the length or the diameter of the pipe.

Accordingly, in consideration of the constraint conditions as described above, the standard system configuration generation unit 32 may have a function of determining the appropriateness of the arrangement of standard components or the positional relationship with respect to surrounding components, so as to display, by color, in accordance with the importance in the standard system configuration diagram, one or more standard components that are required to be changed or one or more standard components that are better to be changed. **In** such a way, supporting the user for a position change or the like of standard components can contribute to prevention of malfunction and a reduction in man-hours for consideration.

The standard system configuration generation unit 32 may have a function of proposing a change of a standard component. For example, the standard system configuration generation unit 32 may provide such a proposal that, while a flange joint does not fit the dimensions, a welding joint would be within a specified dimensional range.

Furthermore, the standard system configuration generation unit 32 may have a function of depicting and proposing an improved plan for the piping route with a lower or substantially the same price in the current standard system configuration adjusting window. The evaluation axis here may be such that the user can select one or a plurality of the evaluation axes and can select a delivery time, a lower pressure loss, a conformity degree, a recommendation level, a shorter piping length, or the like in addition to the price. The improved plan can be proposed by a drawing and a text based on a result of machine learning. This makes it possible to provide the optimal piping route to the user and reduce the burden on the user.

Furthermore, the standard system configuration generation unit 32 may have a function in which, once the user selects a certain plant component before moving the position of the plant component, an expected result for a change of evaluation on the evaluation axis determined in advance is expressed as a difference in color around the selected plant component. As such, by visually presenting a location where a plant component reaches, the user is able to easily determine the arrangement of the standard component. An example of the evaluation axis may be there being a possibility of price improvement, there being no price change, a price change concern level: small, medium, large, or the like. When there is a region where no motion is allowed based on a measuring instrument specification, the region may be visually presented.

Furthermore, the standard system configuration generation unit 32 may have a function of increasing the evaluation of an evaluation axis set in advance or proposing an improved plan of an evaluation axis. Accordingly, it is possible to expect improvement achieved not only by a scheme contributing to the optimization of spatial arrangement but also by a reconsideration of the specification of a plant component. The above proposal can be realized, for example, by a past instance accumulated by the purchase support device 1, a result of machine learning, or a typical improvement pattern registered in advance.

Furthermore, the standard system configuration generation unit 32 may have a function of quoting a typical man-hour from the specification of j oints of respective selected standard components or from the information on a piping route, making a quotation of construction costs via calculation with a general unit price of man-hour, and displaying the total amount of the quotation and the price of system arrangement. Furthermore, a quoted man-hour may be one of the evaluation axes described above. In such a way, preparing the evaluation axes including construction costs can contribute to a reduction of the total cost when the user implements a system.

### [System configuration storage unit 42]

The system configuration storage unit 42 stores information based on a standard system configuration diagram finalized by the user. Fig. 19 is a diagram illustrating an example of information stored in the system configuration storage unit 42. As illustrated in Fig. 19, in the system configuration storage unit 42, pieces of information on respective standard components forming a fluid transport system are listed and stored in descending order of the connection sequence thereof. The information on each standard component may include a block name, a standard component name, a nominal piping diameter (dimension), a nominal pressure (temperature-pressure rating), coordinates of a start point, coordinates of an end point, and a length. These pieces of information are created based on the specification information or the like of each standard component stored in the standard component database 21. The system configuration storage unit 42 may further store a reference delivery time, a reference price, or the like in association with each other.

**In** such a way, in the system configuration storage unit 42, pieces of information (dimensions (nominal diameter), a nominal pressure (temperature-pressure rating), coordinate information, or the like) required for component selection that is a subsequent process are registered in association with each other.

### [Standard system selection unit 33]

The standard system selection unit 33 selects a plurality of standard components having different specifications, respectively, for the primary standard components set in advance out of the standard components stored in the system configuration storage unit 42 and generates a plurality of standard system configuration candidates. An example of the primary standard components may be a pump, a pipe, or the like.

Furthermore, for each of the plurality of standard system configuration candidates, the standard system selection unit 33 acquires calculation blocks corresponding to standard components, which are configuration components forming the plurality of standard system configuration candidates, from the fluid calculation block database 23, connects the acquired calculation blocks to each other in accordance with the connection sequence, and thereby generates a calculation blockchain. The standard system selection unit 33 then provides input conditions, for example, inlet conditions of a pressure, a temperature, and a flow rate to the calculation blockchain to calculate outlet conditions of the fluid transport system, for example, outlet conditions of a pressure, a temperature, and a flow rate.

Fig. 20 illustrates an example of the calculation blockchain. In Fig. 20, for example, "Piping" represents a standard piping calculation block, "Bv" represents a standard ball valve calculation block, "Tpiece" represents a standard T piece calculation block, "Pump" represents a standard pump calculation block (including a reducer for opening diameter adjustment), "FT" represents a standard flow rate calculation block, and "Elbow" represents a standard elbow calculation block.

The standard system selection unit 33 inputs fluid input conditions, specifically, a pressure, a temperature, and a flow rate to a first calculation block BL1 of the calculation blockchain. The outlet conditions calculated in the first calculation block BL1 are provided to the next calculation block BL2 as input conditions. The calculation on the outlet conditions is then sequentially performed in the order of connection of calculation blocks, and thereby the output conditions are calculated in a calculation block BLn, which is finally the end point. These output conditions are the outlet conditions of the entire system in the standard system configuration candidates. Although a temperature, a flow rate, and a pressure are input as the inlet conditions, only the pressure loss may be calculated assuming that the temperature and the flow rate are constant from the inlet to the outlet.

The standard system selection unit 33 generates a calculation blockchain for each of the plurality of standard system configuration candidates and calculates the outlet conditions of each fluid transport system.

The standard system selection unit 33 may have other calculation functions such as, for example, a function of diagnosing a fluid flow at the highest reaching point, a function of calculating net positive suction head (NPSH), a function of diagnosing hammer phenomenon, a function of calculating noise, a function of diagnosing the validity of a design pressure and temperature of each component, or the like.

The function of diagnosing a fluid flow at the highest reaching point is to determine coordinate information and the component thereof at the highest reaching point of a fluid transport system from the coordinate information on each standard component and determine whether or not the pressure condition of the inlet conditions and the outlet conditions is greater than or equal to a predetermined threshold in the calculation block corresponding to the determined component. Accordingly, it is possible to confirm whether or not a flow rate above the minimum flow rate can be ensured in the component located at the highest reaching point in transporting a fluid by the selected standard components. If it is determined that the minimum flow rate is not ensured, for example, the specification of the pump in the standard system configuration candidate of interest may be changed for adjustment so that the minimum flow rate can be ensured in the component located at the highest reaching point.

The function of calculating NPSH is a function of determining whether or not the constraint conditions on the suction side of a pump or a compressor are satisfied, the function of calculating noise is a function of determining whether or not the noise is less than or equal to a predetermined threshold, and the function of diagnosing a hammer phenomenon is a function of determining whether or not a hammer phenomenon (water hammer phenomenon) may occur.

The function of diagnosing the validity of the design pressure and temperature of each component is a function of determining whether or not the operation pressure and temperature at each component is below the design pressure and temperature; in other words, a function of determining whether or not the operation condition is within the nominal pressure range of each component. For example, when the pressure is increased by a pump, the nominal pressure of the plant component downstream of the pump may be changed due to the performance of the pump in some cases. By diagnosing the validity of the design pressure and temperature of each component taking such a case into consideration, it is possible to convey, to the user, the needs for selecting a suitable component, for example, a component durable against a higher pressure or the like.

For each standard system configuration candidate, the standard system selection unit 33 generates a standard system selection window in which information on the primary standard component (a pump specification, a flow rate, a reference nominal piping diameter) and a relationship characteristic between the flow rate and the lifting (head) are indicated and transmits the standard system selection window to the client terminal 70.

Fig. 21 is a diagram illustrating an example of the standard system selection window. In the standard system selection window, expected operation conditions are displayed for each standard system configuration candidate. Specifically, in the standard system selection window, a pump model type, a flow rate, a reference nominal piping diameter, and a value of flow velocity are displayed for each standard system configuration candidate. A diagnosis result from each calculation function described above, for example, a diagnosis result as to whether or not the minimum flow rate can be ensured at the highest reaching point, a calculation result for the NPSH, a risk of a hammer phenomenon, a noise level, a diagnosis result for the validity of design pressure and temperature of each component, or the like may be also displayed as one of the factors for making a decision.

By displaying diagnosis results from respective calculation functions in such a way, it is possible to provide the user with factors for making a decision based on various points of view and allow the user to select a standard system configuration candidate that best meets the needs.

Furthermore, in the standard system selection window, information on a price, a delivery time, or the like may be displayed in addition.

In the standard system selection window, the operating point of the entire system may be displayed. In Fig. 21, operation points of the entire system are displayed on graphs (for example, each as the intersection of a performance curve and a resistance curve on a Q (flow rate)-H (head) plane). Such operation points are computed in consideration of the output conditions of the system calculated in the calculation blockchain described above.

In such a way, the operation points of the entire system and the specification information is presented to the user, and thus the user is able to select and procure a set of a plurality of plant components forming a fluid transport system with the same feeling as selecting a single plant component. Consideration on the selection including the peripheral facility configuration is also made possible.

Furthermore, the standard system selection window may be provided with an input part used for providing an instruction of increase or decrease of the flow rate condition or an input part used for increasing or decreasing the opening diameter condition of piping when there is no desired one in the presented standard system configuration candidates. When these input parts are operated, determination of a standard component is performed again and a plurality of standard system configuration candidates are generated again in accordance with the input instruction, and calculation on the outlet condition or the like described above is performed for each standard system configuration candidate.

The user selects any of the standard system configuration candidates that meets the needs and presses the send button BT2 in the standard system selection window. Accordingly, the information on the standard system configuration candidate selected by the user is transmitted to the purchase support device 1.

The standard system selection unit 33 updates the information on the system configuration storage unit 42 based on the information on the standard system configuration candidate selected by the user. Thus, various information illustrated in Fig. 19 (the name and the specification data or the like of each standard component forming a fluid transport system) is updated based on the information on the standard system configuration candidate selected by the user.

### [System component selection unit 34]

The system component selection unit 34 selects one or a plurality of supplier components corresponding to respective standard components forming a standard system configuration diagram from the supplier component database 22. Specifically, the system component selection unit 34 selects a plant component corresponding to each standard component stored in the system configuration storage unit 42 (hereafter, referred to as a "supplier component") from the supplier component database 22. At this time, the system component selection unit 34 preferably selects a plurality of supplier components sold by different suppliers for each standard component.

For example, for each standard component, the system component selection unit 34 selects a plurality of supplier components matching the conditions based on the name and the specification data (for example, the design pressure, the design temperature, the nominal diameter, or the like) of the standard component and acquires the price, the delivery time, and option information on the supplier component from the supplier component database 22. For example, in a case of a valve, the supplier component is selected based on the nominal pressure and the size (for example, the nominal diameter).

Herein, some suppliers may require a unique requirement in selection of supplier components, and in such a case, it is necessary to inquire the user of the information thereon. In such a case, the system component selection unit 34 may inquire the user of additional entry by displaying an entry form or the like, which are used for the user to fill in with necessary information, on the client terminal 70.

In such a way, the system component selection unit 34 selects one or a plurality of supplier components (for example, supplier components by company A, company B, company C, or the like) corresponding to respective standard components such as a pipe, a ball valve, or a pump, and then the system component selection unit 34 stores information on the selected supplier components in the component candidate storage unit 43 in association with each standard component.

### [Component candidate storage unit 43]

The component candidate storage unit 43 stores information on supplier components in association with each block forming a standard system configuration diagram. Fig. 22 is a diagram illustrating an example of the data stored in the component candidate storage unit 43. As illustrated in Fig. 22, the component candidate storage unit 43 stores suppliers, model numbers, product names, specification information, and information on prices and delivery times in association with configuration elements (block names). Herein, the information acquired from the supplier component database 22 (see Fig. 5) can be written as the suppliers, the model numbers, the product names, the specification information, and the information on prices and delivery times.

### [Selection candidate generation unit 35]

The selection candidate generation unit 35 generates at least one system configuration candidate, which is a combination of supplier components forming a fluid transport system, based on a plurality of supplier components stored in the component candidate storage unit 43, and the selection candidate generation unit 35 transmits the system configuration candidate to the client terminal 70.

Specifically, the selection candidate generation unit 35 generates a plurality of system configuration candidates in accordance with a predetermined evaluation criterion out of a plurality of supplier components stored in the component candidate storage unit 43. The evaluation criterion may be, for example, the lowest price, the shortest delivery time, a lower price and shorter delivery time, and recommendation.

The lowest price is a candidate of a combination of supplier components for the lowest total amount of the plant components forming the flow transport system, and the shortest delivery time is a combination of supplier components for the shortest delivery time of plant components forming the fluid transport system. The lower price and shorter delivery time is evaluated from both the price and the delivery time, which is, for example, a combination of supplier components having the highest evaluation value obtained by substituting respective values into an evaluation computing formula including a price and a delivery time as parameters. The recommendation is, for example, a combination of components having the highest overall evaluation value of a price and a delivery time plus a further evaluation index. For example, respective evaluation values of a price, a delivery time, and a customer review score (the past evaluation information provided by users) are substituted into a predetermined evaluation value computing formula, and thereby an overall evaluation value is calculated on a supplier component basis, so as to determine a combination of supplier components having the highest calculated overall evaluation value.

The evaluation value computing formula can be set in any manner. For example, evaluation of each item may be rated on a 10-point scale, and a sum value of these rated values may be used, or a weighting factor may be set for each item, and a sum value of products of the rated values and the weighting factors for each item may be used. The past record or the past record of similar design by the administrator of the purchase support device 1, the past record from the operation of the purchase support device 1, or the like may be used for machine learning on the overall evaluation values, and the system configuration candidates may be indicated in descending order of the closeness to the machine learning result as the order about recommendation levels.

Once generating a plurality of system configuration candidates based on each evaluation criterion, the selection candidate generation unit 35 generates a comparison selection window in which these system configuration candidates are indicated in a comparable manner and transmits the comparison selection window to the client terminal 70.

Fig. 23 is a diagram illustrating an example of a comparison selection window. In the comparison selection window illustrated in Fig. 23, a system configuration candidate for the lowest price is indicated as pattern 1, a system configuration candidate for the shortest delivery time is indicated as pattern 2, a system configuration candidate evaluated from both of the lower price and the shorter delivery time is indicated as pattern 3, and a recommended system configuration candidate is indicated as pattern 4. For each system configuration candidate, suppliers of respective plant components, produce names, prices, delivery times, and user evaluation scores are displayed. Fig. 23 shows one example of plant components, displaying pipes, ball valves, and pumps. In this comparison selection window, the user is able to select a desired pattern.

The comparison selection window is provided with an individual selection button BT3. This individual selection button BT3 is a button used for moving to an individual selection window that enables the user to select each plant component. Fig. 24 illustrates an example of the individual selection window. In the individual selection window, the information on supplier components is displayed for each configuration element forming the fluid transport system; in other words, the information on supplier components is displayed for each block illustrated in the standard system configuration diagram. The supplier components can be displayed in the order about the price, the delivery time, or the recommendation level. Switching of the display order can be made by switching between tabs.

The user selects any system configuration candidate in the comparison selection window or determines a supplier component for each configuration element in the individual selection window so as to select a supplier component corresponding to each configuration element forming the fluid transport system. Then, the user presses the enter button BT4.

Accordingly, the information on the supplier component corresponding to each configuration element selected by the user is transmitted to the purchase support device 1. The information on the supplier component selected by the user in such a way is stored in the selection component storage unit 44 in association with the information on each configuration element.

The selection candidate generation unit 35 may display an evaluation value of a carbon dioxide emission, a greenhouse gas emission, or the like of the system, for example, as an index when the user selects a system configuration candidate. These evaluation values may be targeted to either one of a period during operation and a period not during operation or may be targeted to both of them. When both of them are targeted, an evaluation value throughout a product life cycle can be provided.

For example, the selection candidate generation unit 35 can calculate a carbon dioxide emission by the following scheme.
- Calculate power consumption of the overall system and multiply the power consumption by a carbon dioxide production per unit power, so as to calculate the carbon dioxide emission during operation from specification information on each supplier component forming each system configuration candidate and an operation plan input by the user (such as information on annual operating hours).
- Calculate carbon dioxide emissions related to manufacturing, transportation, and disposal from data on the greenhouse gas emissions or the like related to the manufacturing, and disposal of each plant component.

In such a way, a carbon dioxide emission is presented as an index in selection of a system configuration candidate, and thus the user is able to select a system configuration candidate also in consideration of the carbon dioxide emission.

### [Selection component storage unit 44]

The selection component storage unit 44 stores information on supplier components corresponding to each configuration element forming a fluid transport system. Furthermore, the selection component storage unit 44 stores coordinate information in association with each supplier component. Fig. 25 is a diagram illustrating an example of data stored in the selection component storage unit 44. As illustrated in Fig. 25, in the selection component storage unit 44, information on supplier component and coordinate information corresponding to respective plant components are registered in association with each other. The information on a supplier component is, for example, information acquired from the component candidate storage unit 43, and the coordinate information is information acquired from the system configuration storage unit 42.

In the selection component storage unit 44, for example, respective supplier components may be listed and stored in the arrangement order of plant components from a transport start point to a transport end point in a system configuration diagram illustrated in Fig. 18.

### [System configuration generation unit 36]

The system configuration generation unit 36 generates a system configuration diagram in which a path is connected from a transport start point to a transport end point based on information on supplier components stored in the selection component storage unit 44 and the coordinate information thereon. Then, the system configuration generation unit 36 generates a system configuration adjusting window including the generated system configuration diagram, and transmits the window data thereof to the client terminal 70. Fig. 26 illustrates an example of the system configuration adjusting window. As illustrated in Fig. 26, in the system configuration adjusting window, detailed information on the selection components is displayed together with the system configuration diagram generated with the supplier components. The system configuration diagram illustrated in Fig. 26 includes a piping adjusting component (modification component). This illustrates a piping difference caused by employing a supplier component instead of a standard component.

Thus, while the standard system configuration diagram illustrated in Fig. 18 is created with the standard components, the system configuration diagram illustrated in Fig. 26 is created with the supplier components. Therefore, due to a difference between the representative specification of the standard component and the specification of the supplier component, the position of the transport end point may differ from the coordinates of the transport end point requested by the user. Accordingly, the difference is indicated as the modification component in the system configuration diagram, and the user is instructed to adjust the position of each component (such as a pump) or the length of piping so that this modification component becomes unnecessary. This can eliminate the difference caused when the supplier component is used and satisfy the conditions of the transport start point and the transport end point input in the request entry window (see Fig. 9).

Upon completion of the adjustment, the user presses the send button BT5. This transmits, to the purchase support device 1, the information on the system configuration diagram obtained after the adjustment, specifically, the coordinate information and the length of each configuration element obtained after the adjustment. In response to receiving the information obtained after the adjustment, the system configuration generation unit 36 updates the coordinate information and the length of each component stored in the selection component storage unit 44 based on this information.

### [Specification confirmation unit 37]

The specification confirmation unit 37 again performs performance calculation based on the data of the system configuration diagram obtained after adjustment, that is, updated data stored in the selection component storage unit 44. For example, the specification confirmation unit 37 acquires calculation blocks corresponding to respective supplier components stored in the selection component storage unit 44 out of a plurality of calculation blocks stored in the fluid calculation block database 23 and connects the acquired calculation blocks to each other based on the arrangement order to generate a calculation blockchain. The specification confirmation unit 37 then provides input conditions (for example, a pressure, a temperature, a flow rate) to the created calculation blockchain to calculate outlet conditions (for example, a pressure, a temperature, a flow rate) of the fluid transport system. For example, the specification confirmation unit 37 may have other calculation functions such as a function of diagnosing a fluid flow at the highest reaching point, a function of calculating NPSH, a function of diagnosing a hammer phenomenon, a function of calculating noise, and a function of diagnosing the validity of the design pressure and temperature of each component.

Upon completion of the performance calculation, the specification confirmation unit 37 generates a final confirmation window including a result of this performance calculation or the like and transmits the final confirmation window to the client terminal 70. Accordingly, the final confirmation window is displayed on the display unit of the client terminal 70.

Fig. 27 is a diagram illustrating an example of the final confirmation window. The final confirmation window displays an operation point when a fluid transport system is configured with selection components (supplier components selected by the user). Specifically, a model type of a pump, a flow rate, a reference nominal piping diameter, and a flow velocity value are displayed in the final confirmation window. The final confirmation window may also display the diagnosis result from each calculation function described above, for example, the diagnosis result as to whether or not the minimum flow rate can be ensured at the highest reaching point, NPSH, the risk of a hammer phenomenon, a noise level, a diagnosis result for the validity of the design pressure and temperature of each component, or the like. Furthermore, the final confirmation window displays information on a price and a delivery time , and displays detailed information on the selection component (for example, a supplier, a model number, a product name, a price, a quantity, or the like).

Once the confirmation button BT6 is pressed by the user, an order placement reservation is finalized, and order placement reservation information is transmitted to the purchase support device 1.

### [Order placement support unit 38]

**In** response to receiving order placement reservation information from the client terminal 70, the order placement support unit 38 supports the user to place an order of the finally confirmed supplier component.

First, the order placement support unit 38 stores information on supplier components finally confirmed by the user in the order placement database 24 as order placement reservation information. The order placement database 24 stores information related to order placements on a user basis. The information related to order placements may be, order placement reservation information, order placement history, order placement status, or the like. For the order placement reservation information, data on the supplier component stored in the selection component storage unit 44 (see Fig. 25) is registered.

Subsequently, the order placement support unit 38 generates the order placement reservation window based on order placement reservation information on the fluid transport system stored in the order placement database 24 and transmits the order placement reservation window to the client terminal 70.

The order placement reservation window displays a price, a delivery time, and an order placement reservation date of the fluid transport system. The order placement reservation window displays various functions for supporting the user to place an order of the system. Fig. 28 is a diagram illustrating an example of the order placement reservation window. The order placement reservation window illustrated in Fig. 28 displays, as an example of the function for support in placing an order of the system, option selection, written quotation confirmation, specification confirmation, and quotation update.

For example, the option selection corresponds to a function of presenting, to the user, option information on the entire fluid transport system or each supplier component forming the fluid transport system and allowing the user to select necessary option information. For example, once the option selection button BT7 provided in the order placement reservation window is pressed by the user, the order placement support unit 38 causes the option selection window used for selection of option information to be displayed on the client terminal 70. Specifically, the order placement support unit 38 acquires option information related to each supplier component stored in the selection component storage unit 44 from the supplier component database 22. Then, the order placement support unit 38 generates an option selection window indicating the acquired option information on each supplier component, and transmits the option selection window to the client terminal 70. In the option selection window, option information on the entire system may be included in addition to the option information on the supplier component.

Fig. 29 is a diagram illustrating an example of the option selection window. As illustrated in Fig. 29, in the option selection window, option information is displayed for the entire system and for each supplier component. The option information may be, for example, information on the option content, the price, and the delivery time. In the option selection window exemplified in Fig. 29, arrangement of a gasket set is indicated as the option information on the entire system. For example, when connection of flanges is taken place, a gasket is required to be inserted. For example, this gasket can be determined from a fluid type, a design temperature, and a design pressure. In the option selection window, once one or a plurality of options are selected and the enter button BT12 is pressed by the user, the information on the option selected by the user is transmitted to the purchase support device 1. Accordingly, the option information (a content, a price, a delivery time, or the like) selected by the user is stored in the order placement reservation information.

The option information may be sales of components related to a heat retention plan. For example, a type of heat retention and a thickness may be displayed as the option information. By planning heat retention along with purchase of a fluid transport system, it is possible to support the user to reduce the manhours.

The written quotation confirmation corresponds to a function of presenting, to the user, a written quotation of supplier components that are currently planned for an order placement. For example, once the written quotation confirmation button BT8 provided in the order placement reservation window is pressed by the user, the order placement support unit 38 acquires information on a price and a delivery time of each supplier component forming a fluid transport system from the order placement reservation information and creates a written quotation based on the acquired information. When option information has been registered in the order placement reservation information, a written quotation including consideration on the option information is created. A written quotation confirmation window used for presenting the written quotation to the user is then created and caused to be displayed on the client terminal 70. Fig. 30 is a diagram illustrating an example of the written quotation confirmation window. In the written quotation confirmation window, delivery time information and the period of validity for the written quotation may be displayed.

The specification confirmation corresponds to a function of presenting, to the user, a specification of supplier components that are currently planned for an order placement. For example, once the specification confirmation button BT9 provided in the order placement reservation window is pressed by the user, the order placement support unit 38 acquires specification information on each supplier component forming a fluid transport system from the order placement reservation information and creates a specification based on the acquired information. A specification confirmation window used for presenting the specification to the user is then created and caused to be displayed on the client terminal 70.

The quotation update is related to an order placement reservation in which the period of validity for a written quotation is about to expire or an order placement reservation in which the period of validity for a written quotation has already expired., The quotation update corresponds to a function of allowing the user to provide an instruction for update of a written quotation based on the current order placement reservation information. For example, once the quotation update button BT10 provided in the order placement reservation window is pressed by the user, the order placement support unit 38 again acquires information on a price and a delivery time of each supplier component forming the fluid transport system from the order placement reservation information and updates the written quotation based on the acquired information. The information on the updated written quotation is then transmitted to the client terminal 70 and thereby presented to the user.

In the order placement reservation window (see Fig. 28), once the order placement button BT11 is pressed by the user, order placement instruction information for providing an instruction for an order placement is transmitted to the purchase support device 1. In response to receiving the order placement instruction information, the order placement support unit 38 places orders of the supplier components onto respective supplier terminals 80 (see Fig. 1) based on the order placement reservation information and changes the order placement reservation information to the order placement information. Even after completion of the order placement, transfer of information between the user and the suppliers via the purchase support device 1 may be made available when an inquiry or the like take place therebetween.

For example, the order placement support unit 38 may have a function of supporting the user for various inquiries during a period from an order placement to a delivery, for example, inquiries about a delivery place, a delivery date and time, or the like. This can reduce the burden of making adjustment time for each delivery, which would conventionally be burdens on both the user and the supplier.

The purchase support device 1 may support the user to manage delivered items via attachment of an information identification tag or barcode to items delivered from suppliers. For example, since the fluid transport system is formed of a plurality of supplier components, the supplier components may be delivered to the user sequentially from different suppliers. In such a case, by providing system identification information common to supplier components used for the same fluid transport system, it is possible for the user to easily know which fluid transport system's component the received supplier component is. This system identification information may be managed in the purchase support device 1.

Next, a purchase support method according to the present embodiment will be briefly described with reference to Fig. 31. A series of processes indicated below is stored as a program (for example, a purchase support program) in the auxiliary storage device 12 of the purchase support device 1 and implemented when the CPU 11 loads this program into the main memory 13 and executes the program.

Fig. 31 is a flowchart illustrating an example of the processing procedure of the purchase support method according to the present embodiment. For convenience of illustration, a purchase support method performed when a user wishes to purchase a fluid transport system configured to transport water from one tank to another will be described below.

First, the purchase support device 1 transmits an interactive condition entry window as illustrated in Fig. 6 to Fig. 17 to the client terminal 70 to be displayed thereon, and thereby allows the user to input various information required in purchasing plant components of the fluid transport system (SA1: condition entry support step). The information input in the condition entry support step is stored in the selection condition storage unit 41 as the selection condition.

Subsequently, the purchase support device 1 generates a standard system configuration diagram of a fluid transport system based on the selection condition and allows the user to adjust the standard system configuration (SA2: standard system configuration generation step). Specifically, standard components forming the fluid transport system are acquired from the standard component database 21 based on the selection conditions stored in the selection condition storage unit 41. Then, the standard components are arranged in order on the piping route connecting from the transport start point to the transport end point, and thereby the standard system configuration diagram is generated. The standard system configuration adjusting window including the standard system configuration diagram (see Fig. 18) is then displayed on the display unit of the client terminal 70 to allow the user to adjust the standard system configuration diagram. The information based on the standard system configuration diagram finalized by the user is stored in the system configuration storage unit 42 (see Fig. 19).

Subsequently, the purchase support device 1 generates a plurality of standard system configuration candidates, and generates a standard system selection window in which these standard system configuration candidates are indicated in a comparable manner (see Fig. 21). Then, the purchase support device 1 allows the user to select a desired standard system configuration candidate (SA3: standard system selection step). At this time, the purchase support device 1 may generate calculation blockchains on a standard system configuration candidate basis to calculate the outlet condition of the system and display the outlet condition in the standard system selection window. Once any of the standard system configuration candidates is selected by the user, the purchase support device 1 updates information of the system configuration storage unit 42 based on the information on the selected standard system configuration candidate.

Next, the purchase support device 1 selects one or a plurality of supplier components corresponding to respective standard components stored in the system configuration storage unit 42 from the supplier component database 22 and stores information on the selected supplier component in the component candidate storage unit 43 in association with each standard component (SA4: system component selection step).

Subsequently, the purchase support device 1 generates a plurality of system configuration candidates in accordance with a predetermined evaluation criterion out of the plurality of supplier components stored in the component candidate storage unit 43, and generates a comparison selection window in which these system configuration candidates are indicated in a comparable manner (see Fig. 23). Then, the purchase support device 1 allows the user to select a desired selection pattern candidate (SA5: selection candidate generation step). Once any of the system configuration candidates is selected by the user, the purchase support device 1 stores the information on the system configuration candidates in the selection component storage unit 44 together with the coordinate information thereon.

Subsequently, the purchase support device 1 generates a system configuration diagram in which a path from the transport start point to the transport end point is connected based on the information on the supplier components stored in the selection component storage unit 44 and the coordinate information thereon, and generates a system configuration adjusting window including the generated system configuration diagram (see Fig. 26). Then, the purchase support device 1 allows the user to adjust the system configuration (SA6: system configuration generation step). Once the system configuration is adjusted by the user, the purchase support device 1 updates the information of the selection component storage unit 44 based on the adjusted system configuration.

Next, the purchase support device 1 performs performance calculation based on the adjusted system configuration diagram, and generates a final confirmation window including a result of the performance calculation or the like (see Fig. 27). Then, the purchase support device 1 allows the user to confirm the specification (SA7: specification confirmation step). Once an order placement reservation is finalized by the user, the purchase support device 1 stores the information on the finally confirmed supplier components in the order placement database 24 as order placement reservation information.

Subsequently, the purchase support device 1 generates an order placement reservation window based on the order placement reservation information on the fluid transport system stored in the order placement database 24 and provides information on the option selection or the like to the user (SA8: order placement support step). Then, in response to receiving an order placement instruction from the user, the purchase support device 1 places an order of the supplier components to respective suppliers based on the order placement reservation information and changes the order placement reservation information to order placement information.

As described above, according to the purchase support device 1, the purchase support method, and the purchase support program of the present embodiment, once the user simply performs simple operation of inputting a selection condition, a plurality of standard components that fit the selection condition are determined, so as to generate a standard system configuration diagram formed of a plurality of determined standard components. Then, one or a plurality of supplier components corresponding to respective standard components forming the standard system configuration diagram are selected, so as to generate at least one system configuration candidate, which is a combination of supplier components forming the fluid transport system, based on the plurality of selected supplier components. The system configuration candidate is presented to the user as a selection candidate.

For example, when selection of plant components is performed, selection criteria or calculation formulae may differ on a supplier basis, and an attempt to perform calculation for respective suppliers all at once may result in an enormous amount of calculation and may take a long time to examine the specification or make a quotation. In contrast, according to the purchase support device 1 of the present embodiment, at the first phase, a standard system configuration diagram is generated with standard components matching selection conditions, and at the next second phase, each supplier component corresponding to each standard component is determined. Since this enables narrowing down of the supplier components, it is possible to reduce the amount of calculation to the minimum while taking the user needs into account and thus shorten the processing time.

The user is able to easily, collectively select a plurality of plant components forming a fluid transport system by selecting a desired one out of the system configuration candidates presented as selection candidates. This makes it possible to easily and efficiently arrange a plurality of plant components. It is therefore possible to effectively shorten the period from condition entry to purchase.

Although the present disclosure has been described using the embodiment, the technical scope of the present disclosure is not limited to the scope described in the above embodiment. Various change or improvements can be added to the above embodiment within the scope not departing from the spirit of the disclosure, and the form to which such a change or improvement is added is also included in the technical scope of the present disclosure.

The flow of the process described in the above embodiment is also an example, an unnecessary step may be deleted, a new step may be added, or the order of processes may be exchanged within the scope not departing from the spirit of the present disclosure.

For example, the purchase support device 1 is not necessarily required to have all the functions illustrated in Fig. 3, and some of the functions can be omitted. For example, the standard system configuration generation unit 32 and the standard system selection unit 33 may be omitted, and the system component selection unit 34 may perform selection of supplier components that fit selection conditions.

Not all the processes of a series of processes illustrated in Fig. 31 are required to be performed, and some of the processes can be omitted. For example, the standard system configuration generation step (SA2) and the standard system configuration selection step (SA3) may be omitted, and selection of supplier components that fit selection conditions may be performed in the system component selection step (SA4).

The purchase support device 1, the purchase support method, and the purchase support program according to one embodiment described above are understood as follows, for example.

The purchase support device (1) according to the first aspect of the present disclosure is a purchase support device (1) configured to support purchase of a fluid transport system including a plurality of plant components, and the purchase support device includes: a condition entry support unit (31) configured to acquire, as selection conditions, a required function and a required specification related to a fluid transport system that a user wishes to purchase; a standard system configuration generation unit (32) configured to determine a plurality of standard components forming the fluid transport system based on the selection conditions from a standard component database (21) storing information on a plurality of standard components related to fluid transport systems and generate a standard system configuration diagram with the plurality of determined standard components being connected to each other; a system component selection unit (34) configured to select one or a plurality of supplier components corresponding to each of the standard components forming the standard system configuration diagram from a supplier component database (22) storing information on supplier components sold by a supplier; and a selection candidate generation unit (35) configured to generate at least one system configuration candidate based on the plurality of selected supplier components and transmit the system configuration candidate to a client terminal (70), the system configuration candidate being a combination of supplier components forming the fluid transport system.

According to the purchase support device (1) of the above aspect, once the user simply performs simple operation of inputting a selection condition, a standard system configuration diagram formed of a plurality of standard components adapted to the selection condition is generated and presented. Then, one or a plurality of supplier components corresponding to each of the standard components forming the standard system configuration diagram are selected, and at least one system configuration candidate, which is a combination of supplier components forming the fluid transport system, is generated based on the plurality of selected supplier components and presented to the user.

For example, when selection of plant components is performed, selection criteria or calculation formulae may differ on a supplier basis, and an attempt to perform calculation for respective suppliers at once may result in an enormous amount of calculation and may take a long time to examine the specification or make a quotation. In contrast, according to the purchase support device (1) of the first aspect described above, at the first phase, a standard system configuration diagram is generated with standard components matching selection conditions, and at the next second phase, each supplier component corresponding to each standard component is selected. Since this enables narrowing down of the supplier components, it is possible to reduce the amount of calculation to the minimum while taking the user needs into account and thus shorten the processing time.

**In** the purchase support device (1) according to the second aspect of the present disclosure, in the first aspect described above, the standard system configuration generation unit (32) generates the standard system configuration diagram by arranging the plurality of standard components on a fluid transport path from a transport start point to a transport end point.

According to the purchase support device (1) of the above aspect, it is possible to generate a standard system configuration diagram in which a plurality of standard components are arranged on a fluid transport path from a transport start point to a transport end point.

**In** the purchase support device (1) according to the third aspect of the present disclosure, in the first aspect or the second aspect described above, the standard system configuration generation unit (32) generates and transmits a standard system configuration adjusting window to the client terminal, the standard system configuration adjusting window allowing the user to perform at least any one of: adjustment of a position and arrangement order of the standard components forming the standard system configuration diagram; addition of piping; a change of a transport path; or a change of a piping length.

According to the purchase support device (1) of the above aspect, the user is able to easily change at least any one of adjustment of the position and the arrangement order of the standard components in the standard system configuration diagram displayed in the standard system configuration adjusting window, addition of piping, a change of the transport path, or a change of the piping length. This enables the user to create a desired standard system configuration by simple operation.

**In** the purchase support device (1) according to the fourth aspect of the present disclosure, in the third aspect described above, the standard system configuration adjusting window enables the user to add and delete a required function.

According to the purchase support device (1) of the above aspect, the user is able to create a desired standard system configuration by simple operation.

The purchase support device (1) according to the fifth aspect of the present disclosure includes, in any one of the first aspect to the fourth aspect described above, a standard system selection unit (33) configured to generate a plurality of standard system configuration candidates each having a different specification for any one of the plurality of standard components forming the fluid transport system, and transmit, to the client terminal, a standard system selection window in which the plurality of standard system configuration candidates are indicated in a comparable manner.

According to the purchase support device (1) of the above aspect, a plurality of standard system configuration candidates are presented to the user in a comparable manner. This enables the user to easily compare and examine these standard system configuration candidates and efficiently select a desired candidate.

In the purchase support device (1) according to the sixth aspect of the present disclosure, in the fifth aspect described above, for each of the plurality of standard system configuration candidates, the standard system selection unit (33) extracts calculation blocks corresponding to each standard component from a fluid calculation block database (23) storing a plurality of calculation blocks in which plant components and flow rate computing formulae are associated with each other, connects the extracted calculation blocks in accordance with a connection sequence to generate a calculation blockchain, and provides an input condition to the calculation blockchain to calculate an output condition of each of the standard system configuration candidates, and each of the standard system configuration candidates and the output condition are displayed in association with each other in the standard system selection window.

According to the purchase support device (1) of the above aspect, the output condition of each standard system configuration candidate can be calculated by a simple process. When the arrangement order of the standard components is changed by the user, it is possible to easily perform computation of the output condition by simply changing the arrangement of the calculation blocks based on the changed arrangement.

In the purchase support device (1) according to the seventh aspect of the present disclosure, in the fifth aspect or the sixth aspect described above, each of the standard system configuration candidates and an operation condition are displayed in association with each other in the standard system selection window.

According to the purchase support device (1) of the above aspect, the operation condition is displayed in association with each standard system configuration candidate. Thus, the user is able to compare and examine a plurality of standard system configuration candidates by taking the operation condition into consideration.

In the purchase support device (1) according to the eighth aspect of the present disclosure, in any one of the fifth aspect to the seventh aspect described above, at least any one of a diagnosis result for validity of a design pressure temperature of each component, a diagnosis result for a fluid flow at the highest reaching point, a calculation result for NPSH, a diagnosis result for a hammer phenomenon, or a diagnosis result for noise is displayed in the standard system selection window in association with each of the standard system configuration candidates.

According to the purchase support device (1) of the above aspect, it is possible to compare and examine a plurality of standard system configuration candidates in consideration of a diagnosis result for validity of a design pressure temperature of each component, a diagnosis result for a fluid flow at the highest reaching point, a calculation result for NPSH, a diagnosis result for a hammer phenomenon, a diagnosis result for noise, or the like.

In the purchase support device (1) according to the ninth aspect of the present disclosure, in any one of the fifth aspect to the eighth aspect described above, when the presented standard system configuration candidates do not include what the user wishes to purchase, an input part is provided on the standard system selection window used by the user to provide an instruction of at least any one of an increase or decrease of a flow rate condition or an increase or decrease of an opening diameter condition of piping.

According to the purchase support device (1) of the above aspect, when the plurality of presented standard system configuration candidates do not include what the user wishes to purchase, the user is able to cause a plurality of a new standard system configuration candidate to be presented by changing the design condition.

In the purchase support device (1) according to the tenth aspect of the present disclosure, in any one of the first aspect to the ninth aspect described above, the selection candidate generation unit (35) generates a plurality of system configuration candidates having different supplier components forming a fluid transport system in accordance with a predetermined evaluation criterion out of the plurality of selected supplier components and transmits, to the client terminal (70), a comparison selection window in which the plurality of generated system configuration candidates are indicated in a comparable manner.

According to the purchase support device (1) of the above aspect, it is possible to easily select a desired system configuration candidate by comparing and examining a plurality of system configuration candidates.

In the purchase support device (1) according to the eleventh aspect of the present disclosure, in the tenth aspect described above, the evaluation criterion is a criterion including at least any one of a price or a delivery time.

According to the purchase support device (1) of the above aspect, a plurality of system configuration candidates formed of supplier components superior in terms of the price and the delivery time can be presented to the user. This enables the user to select a desired system configuration candidate in terms of the price or the delivery time.

The purchase support device (1) according to the twelfth aspect of the present disclosure includes, in any one of the first aspect to the eleventh aspect described above, a system configuration generation unit (36) configured to generate a system configuration diagram with supplier components being connected to each other, the supplier components being selected by the user out of the plurality of supplier components presented as selection candidates, and generate a system configuration adjusting window used by the user to adjust at least any one of a change of a piping route, a change of a piping length, or a change of a piping arrangement angle in the system configuration diagram.

According to the purchase support device (1) of the above aspect, the piping in the system configuration diagram presented in the system configuration adjusting window is adjusted, and thereby a fluid transport system formed of a plurality of supplier components matching the selection condition can be obtained.

In the purchase support device (1) according to the thirteenth aspect of the present disclosure, in the twelfth aspect described above, when transport end point coordinates differ from transport end point coordinates input as the selection conditions, a modification component for adjusting the difference is included in the system configuration diagram of the system configuration adjusting window.

According to the purchase support device (1) of the above aspect, the amount of deviation between the transport end point coordinates in the system configuration diagram and the transport end point coordinates input as the selection condition can be visualized and indicated to the user. The user is able to obtain a fluid transport system formed of supplier components matching the selection condition by adjusting piping forming the system configuration diagram so that the length of the modification component becomes zero.

The purchase support device (1) according to the fourteenth aspect of the present disclosure is a purchase support device (1) configured to support purchase of a fluid transport system including a plurality of components, and the purchase support device includes: a condition entry support unit (31) configured to acquire, as selection conditions, a required function and a required specification and information on a transport start point and a transport end point related to a fluid transport system that a user wishes to purchase; and a system configuration generation unit (36) configured to determine a supplier component forming the fluid transport system based on the acquired selection conditions, arrange the determined supplier component on a fluid transport path from a transport start point to a transport end point to generate a system configuration diagram, and provide a system configuration adjusting window to the user, the system configuration adjusting window allowing the user to adjust the generated system configuration diagram.

According to the purchase support device (1) of the above aspect, the user is able to easily perform, with simple operation, adjustment of supplier components in the system configuration diagram displayed in the system configuration adjusting window.

The purchase support device (1) according to the fifteenth aspect of the present disclosure is a purchase support device (1) configured to support purchase of a fluid transport system including a plurality of plant components, and the purchase support device includes: a condition entry support unit (31) configured to acquire, as selection conditions, a required function and a required specification related to a fluid transport system that a user wishes to purchase; a system configuration generation unit (36) configured to determine supplier components forming the fluid transport system based on the acquired selection conditions and arrange the determined supplier components on a fluid transport path from a transport start point to a transport end point to generate a system configuration diagram; and a specification confirmation unit (37) configured to extract calculation blocks corresponding to each of the plurality of supplier components forming the fluid transport system from a fluid calculation block database (23) storing a plurality of calculation blocks in which plant components and flow rate computing formulae are associated with each other, connect the extracted calculation blocks in accordance with a connection sequence to generate a calculation blockchain, and provide an input condition to the calculation blockchain to calculate an output condition of the fluid transport system.

According to the purchase support device (1) of the above aspect, the output condition of the system can be calculated by a simple process. When the arrangement order of the supplier components is changed by the user, it is possible to easily perform computation of the output condition by simply changing the arrangement of the calculation blocks based on the changed arrangement.

The purchase support method according to the sixteenth aspect of the present disclosure is a purchase support method for supporting purchase of a fluid transport system including a plurality of plant components, and a computer performs the purchase support method including steps of: acquiring, as selection conditions, a required function and a required specification related to a fluid transport system that a user wishes to purchase; determining a plurality of standard components forming the fluid transport system based on the selection conditions from a standard component database storing information on a plurality of standard components related to fluid transport systems and generating a standard system configuration diagram with the plurality of determined standard components being connected to each other; selecting one or a plurality of supplier components corresponding to each of the standard components forming the standard system configuration diagram from a supplier component database storing information on supplier components sold by a supplier; and generating at least one system configuration candidate based on the plurality of selected supplier components and transmitting the system configuration candidate to a client terminal, the system configuration candidate being a combination of supplier components forming the fluid transport system.

The purchase support method according to the seventeenth aspect of the present disclosure is a purchase support method for supporting purchase of a fluid transport system including a plurality of components, and a computer performs the purchase support method including steps of: acquiring, as selection conditions, a required function and a required specification and information on a transport start point and a transport end point related to a fluid transport system that a user wishes to purchase; and determining a supplier component forming the fluid transport system based on the acquired selection conditions, arranging the determined supplier component on a fluid transport path from a transport start point to a transport end point to generate a system configuration diagram, and providing a system configuration adjusting window to the user, the system configuration adjusting window allowing the user to adjust the generated system configuration diagram.

The purchase support method according to the eighteenth aspect of the present disclosure is a purchase support method for supporting purchase of a fluid transport system including a plurality of plant components, and a computer performs the purchase support method including steps of: acquiring as selection conditions, a required function and a required specification related to a fluid transport system that a user wishes to purchase; determining supplier components forming the fluid transport system based on the acquired selection conditions and arranging the determined supplier components on a fluid transport path from a transport start point to a transport end point to generate a system configuration diagram; and extracting calculation blocks corresponding to each of the plurality of supplier components forming the fluid transport system from a fluid calculation block database storing a plurality of calculation blocks in which supplier components and flow rate computing formulae are associated with each other, connecting the extracted calculation blocks in accordance with a connection sequence to generate a calculation blockchain, and providing an input condition to the calculation blockchain to calculate an output condition of the fluid transport system.

The purchase support program according to the nineteenth aspect of the present disclosure is a purchase support program for causing a computer to function as the purchase support device according to any one of the first aspect to the fifteenth aspect described above.

### [Reference Signs List]

- 1: purchase support device
- 11: CPU
- 12: auxiliary storage device
- 13: main memory
- 14: communication device
- 15: input unit
- 16: display unit
- 21: standard component database
- 22: supplier component database
- 23: fluid calculation block database
- 24: order placement database
- 31: condition entry support unit
- 32: standard system configuration generation unit
- 33: standard system selection unit
- 34: system component selection unit
- 35: selection candidate generation unit
- 36: system configuration generation unit
- 37: specification confirmation unit
- 38: order placement support unit
- 41: selection condition storage unit
- 42: system configuration storage unit
- 43: component candidate storage unit
- 44: selection component storage unit
- 70: client terminal
- 80: supplier terminal
- 311: entry assist unit

## Claims

1. A purchase support device configured to support purchase of a fluid transport system including a plurality of plant components, the purchase support device comprising:
a condition entry support unit configured to acquire, as selection conditions, a required function and a required specification related to a fluid transport system that a user wishes to purchase;
a standard system configuration generation unit configured to determine a plurality of standard components forming the fluid transport system based on the selection conditions from a standard component database storing information on a plurality of standard components related to fluid transport systems, and generate a standard system configuration diagram with the plurality of determined standard components being connected to each other;
a system component selection unit configured to select one or a plurality of supplier components corresponding to each of the standard components forming the standard system configuration diagram from a supplier component database storing information on supplier components sold by a supplier; and
a selection candidate generation unit configured to generate at least one system configuration candidate based on the plurality of selected supplier components, and transmit the system configuration candidate to a client terminal, the system configuration candidate being a combination of supplier components forming the fluid transport system.

2. The purchase support device according to claim 1, wherein the standard system configuration generation unit generates the standard system configuration diagram by arranging the plurality of standard components on a fluid transport path from a transport start point to a transport end point.

3. The purchase support device according to claim 1, wherein the standard system configuration generation unit generates and transmits a standard system configuration adjusting window to the client terminal, the standard system configuration adjusting window allowing the user to perform at least any one of: adjustment of a position and arrangement order of the standard components forming the standard system configuration diagram; addition of piping; a change of a transport path; or a change of a piping length.

4. The purchase support device according to claim 3, wherein the standard system configuration adjusting window enables the user to add and delete a required function.

5. The purchase support device according to claim 1 further comprising a standard system selection unit configured to generate a plurality of standard system configuration candidates each having a different specification for any one of the plurality of standard components forming the fluid transport system, and transmit, to the client terminal, a standard system selection window in which the plurality of standard system configuration candidates are indicated in a comparable manner.

6. The purchase support device according to claim 5,
wherein the standard system selection unit is configured to, for each of the plurality of standard system configuration candidates, extract calculation blocks corresponding to each standard component from a fluid calculation block database storing a plurality of calculation blocks in which plant components and flow rate computing formulae are associated with each other, connect the extracted calculation blocks in accordance with a connection sequence to generate a calculation blockchain, and provide an input condition to the calculation blockchain to calculate an output condition of each of the standard system configuration candidates, and
wherein each of the standard system configuration candidates and the output condition are displayed in association with each other in the standard system selection window.

7. The purchase support device according to claim 5, wherein each of the standard system configuration candidates and an operation condition are displayed in association with each other in the standard system selection window.

8. The purchase support device according to claim 5, wherein at least any one of a diagnosis result for validity of a design pressure and temperature of each component, a diagnosis result for a fluid flow at the highest reaching point, a calculation result for NPSH, a diagnosis result for a hammer phenomenon, or a diagnosis result for noise is displayed in the standard system selection window in association with each of the standard system configuration candidates.

9. The purchase support device according to claim 5, wherein when the presented standard system configuration candidates do not include what the user wishes to purchase,
an input part is provided on the standard system selection window used by the user to provide an instruction of at least any one of an increase or decrease of a flow rate condition or an increase or decrease of an opening diameter condition of piping.

10. The purchase support device according to claim 1, wherein the selection candidate generation unit generates a plurality of system configuration candidates having different supplier components forming a fluid transport system in accordance with a predetermined evaluation criterion out of the plurality of selected supplier components and transmits, to the client terminal, a comparison selection window in which the plurality of generated system configuration candidates are indicated in a comparable manner.

11. The purchase support device according to claim 10, wherein the evaluation criterion is a criterion including at least any one of a price or a delivery time.

12. The purchase support device according to claim 1 further comprising a system configuration generation unit configured to generate a system configuration diagram with supplier components being connected to each other, the supplier components being selected by the user out of the plurality of supplier components presented as selection candidates, and generate a system configuration adjusting window used by the user to adjust at least any one of a change of a piping route, a change of a piping length, or a change of a piping arrangement angle in the system configuration diagram.

13. The purchase support device according to claim 12, wherein when transport end point coordinates differ from transport end point coordinates input as the selection conditions, a modification component for adjusting the difference is included in the system configuration diagram of the system configuration adjusting window.

14. A purchase support device configured to support purchase of a fluid transport system including a plurality of components, the purchase support device comprising:
a condition entry support unit configured to acquire, as selection conditions, a required function and a required specification and information on a transport start point and a transport end point related to a fluid transport system that a user wishes to purchase; and
a system configuration generation unit configured to determine a supplier component forming the fluid transport system based on the acquired selection conditions, arrange the determined supplier component on a fluid transport path from a transport start point to a transport end point to generate a system configuration diagram, and provide a system configuration adjusting window to the user, the system configuration adjusting window allowing the user to adjust the generated system configuration diagram.

15. A purchase support device configured to support purchase of a fluid transport system including a plurality of plant components, the purchase support device comprising:
a condition entry support unit configured to acquire, as selection conditions, a required function and a required specification related to a fluid transport system that a user wishes to purchase;
a system configuration generation unit configured to determine supplier components forming the fluid transport system based on the acquired selection conditions and arrange the determined supplier components on a fluid transport path from a transport start point to a transport end point to generate a system configuration diagram; and
a specification confirmation unit configured to extract calculation blocks corresponding to each of the plurality of supplier components forming the fluid transport system from a fluid calculation block database storing a plurality of calculation blocks in which plant components and flow rate computing formulae are associated with each other, connect the extracted calculation blocks in accordance with a connection sequence to generate a calculation blockchain, and provide an input condition to the calculation blockchain to calculate an output condition of the fluid transport system.

16. A purchase support method for supporting purchase of a fluid transport system including a plurality of plant components, a computer performing the purchase support method comprising:
acquiring, as selection conditions, a required function and a required specification related to a fluid transport system that a user wishes to purchase;
determining a plurality of standard components forming the fluid transport system based on the selection conditions from a standard component database storing information on a plurality of standard components related to fluid transport systems and generating a standard system configuration diagram with the plurality of determined standard components being connected to each other;
selecting one or a plurality of supplier components corresponding to each of the standard components forming the standard system configuration diagram from a supplier component database storing information on supplier components sold by a supplier; and
generating at least one system configuration candidate based on the plurality of selected supplier components and transmitting the system configuration candidate to a client terminal, the system configuration candidate being a combination of supplier components forming the fluid transport system.

17. A purchase support method for supporting purchase of a fluid transport system including a plurality of components, a computer performing the purchase support method comprising:
acquiring, as selection conditions, a required function and a required specification and information on a transport start point and a transport end point related to a fluid transport system that a user wishes to purchase; and
determining a supplier component forming the fluid transport system based on the acquired selection conditions, arranging the determined supplier component on a fluid transport path from a transport start point to a transport end point to generate a system configuration diagram, and providing a system configuration adjusting window to the user, the system configuration adjusting window allowing the user to adjust the generated system configuration diagram.

18. A purchase support method for supporting purchase of a fluid transport system including a plurality of plant components, a computer performing the purchase support method comprising:
acquiring as selection conditions, a required function and a required specification related to a fluid transport system that a user wishes to purchase;
determining supplier components forming the fluid transport system based on the acquired selection conditions and arranging the determined supplier components on a fluid transport path from a transport start point to a transport end point to generate a system configuration diagram; and
extracting calculation blocks corresponding to each of the plurality of supplier components forming the fluid transport system from a fluid calculation block database storing a plurality of calculation blocks in which supplier components and flow rate computing formulae are associated with each other, connecting the extracted calculation blocks in accordance with a connection sequence to generate a calculation blockchain, and providing an input condition to the calculation blockchain to calculate an output condition of the fluid transport system.

19. A purchase support program for causing a computer to function as the purchase support device according to any one of claims 1 to 15.
